(19) Europäisches Patentamt
European Patent Office
Office européen des brevets

(11) EP 3 101 705 B1

(12) **EUROPEAN PATENT SPECIFICATION**

(45) Date of publication and mention of the grant of the patent:
**03.07.2019 Bulletin 2019/27**

(21) Application number: **15740797.4**

(22) Date of filing: **21.01.2015**

(51) Int Cl.:
***H01L 51/30*** $^{(2006.01)}$ ***H01L 51/05*** $^{(2006.01)}$
***C08G 61/12*** $^{(2006.01)}$

(86) International application number:
**PCT/JP2015/051487**

(87) International publication number:
**WO 2015/111604 (30.07.2015 Gazette 2015/30)**

(54) **ORGANIC TRANSISTOR, COMPOUND, ORGANIC SEMICONDUCTOR MATERIAL FOR NON-LIGHT-EMITTING ORGANIC SEMICONDUCTOR DEVICE, MATERIAL FOR ORGANIC TRANSISTOR, COATING SOLUTION FOR NON-LIGHT-EMITTING ORGANIC SEMICONDUCTOR DEVICE, AND ORGANIC SEMICONDUCTOR FILM FOR NON-LIGHT-EMITTING ORGANIC SEMICONDUCTOR DEVICE**

ORGANISCHER TRANSISTOR, VERBINDUNG, ORGANISCHES HALBLEITERMATERIAL EINES NICHTLEUCHTENDEN ORGANISCHEN HALBLEITERBAUELEMENTS, MATERIAL FÜR EINEN ORGANISCHEN TRANSISTOR, BESCHICHTUNGSLÖSUNG FÜR NICHTLEUCHTENDES ORGANISCHES HALBLEITERBAUELEMENT UND ORGANISCHE HALBLEITERFOLIE EINES NICHTLEUCHTENDEN ORGANISCHEN HALBLEITERBAUELEMENTS

TRANSISTOR ORGANIQUE, COMPOSÉ, MATÉRIAU SEMI-CONDUCTEUR ORGANIQUE POUR DISPOSITIVE À SEMI-CONDUCTEUR ORGANIQUE NON LUMINEUX, MATÉRIAU POUR TRANSISTOR ORGANIQUE, SOLUTION DE REVÊTEMENT POUR DISPOSITIF À SEMI-CONDUCTEUR ORGANIQUE NON LUMINEUX, ET FILM SEMI-CONDUCTEUR ORGANIQUE POUR DISPOSITIF À SEMI-CONDUCTEUR ORGANIQUE NON LUMINEUX

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **27.01.2014 JP 2014012057**

(43) Date of publication of application:
**07.12.2016 Bulletin 2016/49**

(73) Proprietor: **FUJIFILM Corporation**
**Minato-ku**
**Tokyo 106-8620 (JP)**

(72) Inventors:
- **NAKAYAMA Takafumi**
**Ashigarakami-gun**
**Kanagawa 258-8577 (JP)**
- **KANEKO Akihiro**
**Ashigarakami-gun**
**Kanagawa 258-8577 (JP)**
- **MASUI Kensuke**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(56) References cited:
**WO-A1-2013/030325** **WO-A1-2013/066973**
**DE-A1- 3 618 838** **JP-A- 2007 088 222**
**JP-A- 2011 124 422** **JP-A- 2013 201 252**

- **H.Z. CHEN ET AL: "Synthesis, optical and electroluminescent properties of a novel Indacene", SYNTHETIC METALS, vol. 139, no. 2, 1 September 2003 (2003-09-01), pages 529-534, XP055326460, CH ISSN: 0379-6779, DOI: 10.1016/S0379-6779(03)00338-2**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

## BACKGROUND OF THE INVENTION

1. Field of the Invention

The present invention relates to an organic transistor, an organic semiconductor film, an organic semiconductor material, and the like. Specifically, the present invention relates to a compound having a moiety in which two pyrrole rings are condensed, an organic transistor, an organic semiconductor material for a non-light-emitting organic semiconductor device, a material for an organic transistor, a coating solution for a non-light-emitting organic semiconductor device, and an organic semiconductor film for a non-light-emitting organic semiconductor device.

2. Description of the Related Art

The devices using organic semiconductor materials are drawing great attention because they are expected to be superior in various aspects to the devices using inorganic semiconductor materials of the related art such as silicon. Examples of the devices using organic semiconductor materials include a photoelectric conversion element such as an organic solar cell or a solid-state imaging element using organic semiconductor materials as photoelectric conversion materials, an organic transistor (referred to as an organic thin-film transistor in some cases) having non-light-emitting properties (in the present specification, "non-light-emitting" refers to properties by which a luminous efficiency of equal to or less than 1 lm/W is obtained in a case where electric currents are applied to a device at a current density of 0.1 $mW/cm^2$ at room temperature in the atmosphere; non-light-emitting organic semiconductor devices mean organic semiconductor devices excluding light-emitting organic semiconductor devices such as organic electroluminescence elements), and the like. The devices using organic semiconductor materials are likely to make it possible to prepare large area elements at lower temperature and lower costs compared to the devices using inorganic semiconductor materials. Furthermore, the characteristics of the materials can be easily changed by varying the molecular structure thereof. Therefore, the materials show a wide variation and can realize functions or elements that cannot be obtained by inorganic semiconductor materials.

For example, JP2010-535270A discloses an organic semiconductor material having an indacenedione skeleton or a skeleton analogous thereto, and describes that the organic semiconductor material exhibits bipolar semiconductor activity, high solvent treatability, and atmospheric stability by which only a slight mobility change occurs even when the material is stored for 5 months in the air.

Meanwhile, JP2008-056814A describes polyindigo as a compound which is similar to the compound described in JP2010-535270A in terms of the skeleton of a mother nucleus but is completely different from the compound described in JP2010-535270A in terms of the pattern of linkage between repeating units. Although JP2008-056814A focuses on a method for efficiently manufacturing high-strength polyindigo, it does not describe the application of polyindigo to an organic transistor.

WO 2013/066973 describes fused thiophene compounds having the specified formulas shown in this document. These compounds are used in thin film-based and other devices.

## SUMMARY OF THE INVENTION

Under the circumstances described above, the inventors of the present invention manufactured an organic transistor element having a bottom gate/top contact structure by using the polycyclic condensed polymer described in JP2010-535270A. As a result, the inventors found that the hole mobility thereof is about $10^{-5}$ to $10^{-3}$, signifying low carrier mobility.

An object of the present invention is to provide an organic transistor having high carrier mobility.

In order to achieve the aforementioned object, the inventors of the present invention conducted thorough investigation. As a result, they obtained knowledge that in a compound having, as a repeating unit, a polycyclic condensed skeletal structure which is a novel acceptor skeletal structure containing a specific 5-membered aromatic heterocyclic ring having a nitrogen atom in a specific position, overlapping of HOMO sufficiently occurs between molecules when the compound is crystallized, and thus the carrier mobility is improved. Based on the knowledge, the inventors accomplished the present invention.

The present invention as specific means for achieving the aforementioned object is constituted as below.

[1] An organic transistor comprising a compound having a repeating unit represented by the following Formula (1-2), or (1-3) in a semiconductor active layer, wherein said compound is an oligomer wherein the number of the repeating units is 2 to 9 or a polymer wherein the number of the repeating units is equal to or greater than 10:

Formula (1-2)

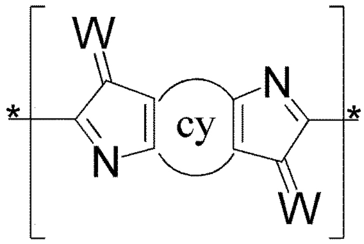

in Formula (1-2),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group, and
each $R^2$ independently represents a cyano group, an acyl group, a (per)fluoroalkyl group, or a (per)fluoroaryl group;

Formula (1-3)

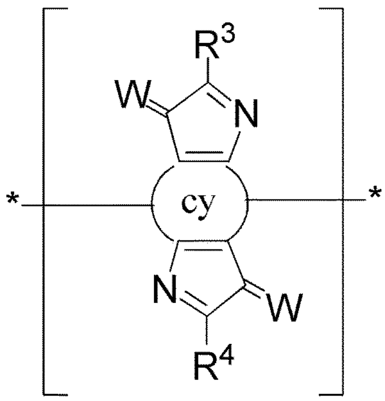

in Formula (1-3),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group,
each $R^2$ independently represents a cyano group, an acyl group, a (per)fluoroalkyl group, or a (per)fluoroaryl group, and
each of $R^3$ and $R^4$ independently represents a hydrogen atom or a monovalent substituent.

[2] The organic transistor described in [1], in which the compound having a repeating unit represented by Formula (1-2), or (1-3) is preferably a compound represented by Formula (1-2).

[3] The organic transistor described in [1] or [2], in which all of W's in Formulae (1-2), and (1-3) are preferably an oxygen atom.

[4] The organic transistor described in any one of [1] to [3], in which the compound having a repeating unit represented by Formula (1-2) is preferably a compound having a partial structure represented by the following Formula (1-2A):

Formula (1-2A)

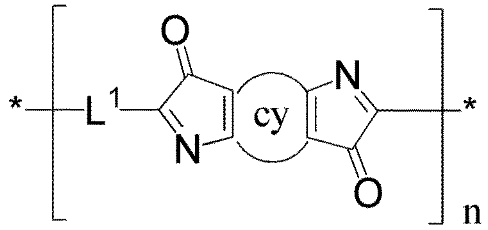

in Formula (1-2A),

Cy represents an aromatic ring or a heterocyclic aromatic ring that may have a substituent,
$L^1$ represents a single bond or a divalent linking group,
n represents an integer of equal to or greater than 2, and two or more Cy's and $L^1$'s may be the same as or different from each other.

[5] The organic transistor described in any one of [1] to [4], in which the compound having a repeating unit represented by Formula (1-2) is preferably a compound having a partial structure represented by the following Formula (1-2B):

Formula (1-2B)

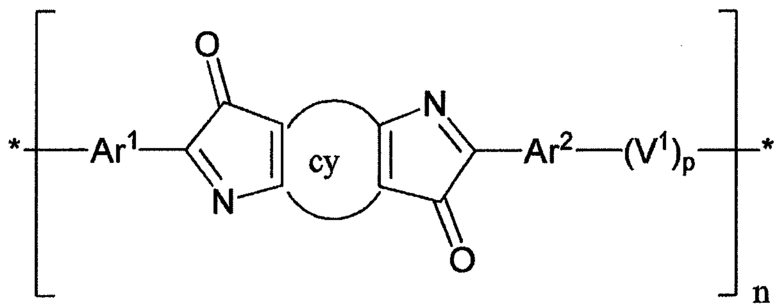

in Formula (1-2B),

Cy represents an aromatic ring or a heterocyclic aromatic ring that may have a substituent,
each of $Ar^1$ and $Ar^2$ independently represents a heteroarylene group or an arylene group,
$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more Cy's, $V^1$'s, $Ar^1$'s, and $Ar^2$'s may be the same as or different from each other.

[6] The organic transistor described in [5], in which the partial structure represented by Formula (1-2B) is preferably a partial structure represented by any of the following Formulae (2-1) to (2-7):

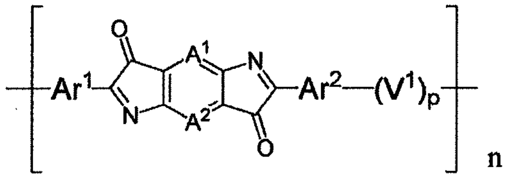

Formula (2-1)

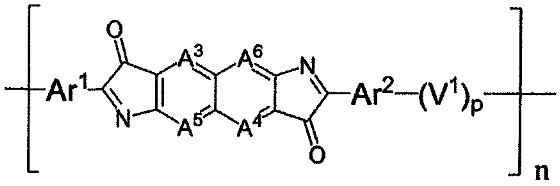

Formula (2-2)

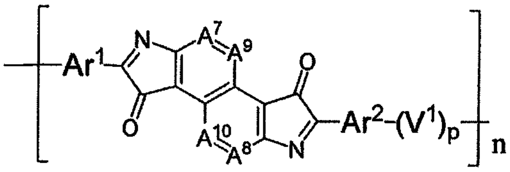

Formula (2-3)

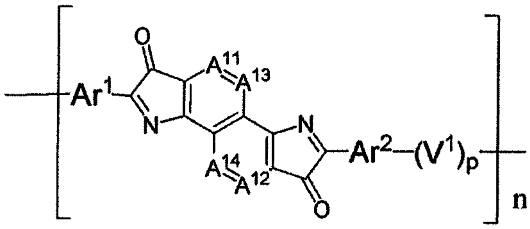

Formula (2-4)

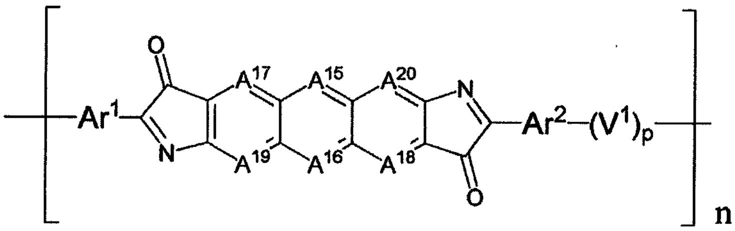

Formula (2-5)

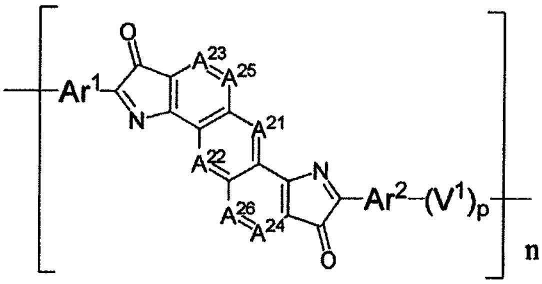

Formula (2-6)

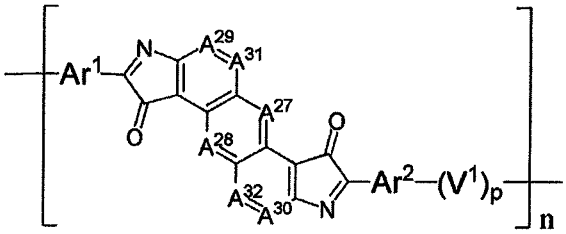

Formula (2-7)

in Formulae (2-1) to (2-7),

each of $A^1$ to $A^{32}$ independently represents $-C(R^0)-$ or a N atom,
each $R^0$ independently represents a hydrogen atom or a substituent, a plurality of $R^0$'s may be the same as or different from each other,
each of $Ar^1$ and $Ar^2$ independently represents a heteroarylene group or an arylene group,

$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more $V^1$'s, $Ar^1$'s, and $Ar^2$'s may be the same as or different from each other.

[7] The organic transistor described in [5] or [6], in which in Formulae (1-2B) and (2-1) to (2-7), $V^1$ is preferably a single bond or a divalent linking group represented by any of the following Formulae (V-1) to (V-17):

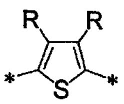
(V-1)
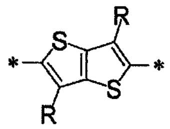
(V-2)
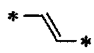
(V-3)
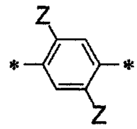
(V-4)
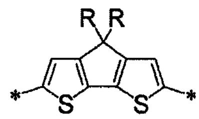
(V-5)
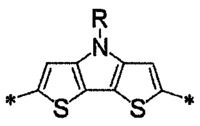
(V-6)
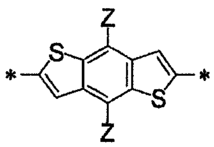
(V-7)
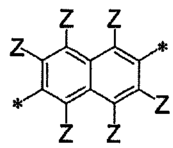
(V-8)
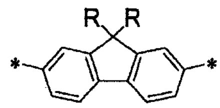
(V-9)
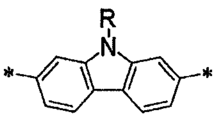
(V-10)
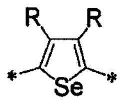
(V-11)
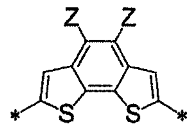
(V-12)
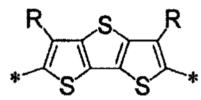
(V-13)
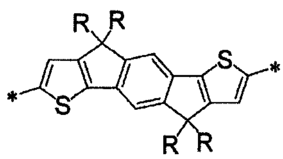
(V-14)
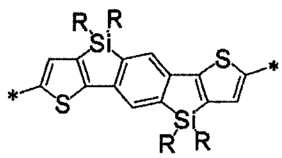
(V-15)
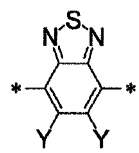
(V-16)
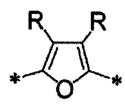
(V-17)

each R in Formulae (V-1), (V-2), (V-5), (V-6), (V-9) to (V-11), (V-13) to (V-15), and (V-17) independently represents a hydrogen atom or an alkyl group, R's adjacent to each other may form a ring by being bonded to each other,
each Z in Formulae (V-4), (V-7), (V-8), and (V-12) independently represents a hydrogen atom, an alkyl group, or an alkoxy group, Z's adjacent to each other may form a ring by being bonded to each other,
each Y in Formula (V-16) independently represents a hydrogen atom, an alkyl group, an alkoxy group, a CN group, or a F atom, and Y's adjacent to each other may form a ring by being bonded to each other.

[8] The organic transistor described in [7], in which in Formulae (1-2B) and (2-1) to (2-7), $V^1$ is preferably a divalent linking group represented by any of Formulae (V-1) to (V-3).

[9] The organic transistor described in any one of [5] to [8], in which in Formulae (1-2B) and (2-1) to (2-7), each of $Ar^1$ and $Ar^2$ is preferably independently a divalent linking group represented by the following Formula (4-1), (4-2), or (4-3):

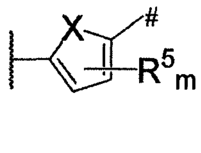

Formula (4-1)

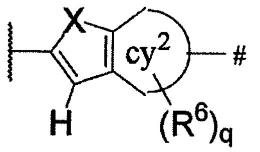

Formula (4-2)

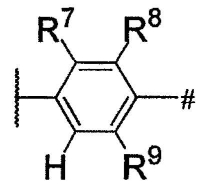

Formula (4-3)

in Formulae (4-1) to (4-3),

X represents a sulfur atom, an oxygen atom, or a Se atom,
$Cy^2$ represents a structure in which 1 to 4 rings are condensed,
each of $R^5$ to $R^9$ independently represents a hydrogen atom or a substituent,
m is 2,
q represents an integer of 0 to 6, when q is equal to or greater than 2, two or more $R^6$'s may be the same as or different from each other,
the wavy line represents a position of bonding to a moiety in which a 3H-pyrrol-3-one ring is condensed, and
# represents a position of bonding to $V^1$.

[10] The organic transistor described in [9], in which in Formulae (1-2B) and (2-1) to (2-7), each of $Ar^1$ and $Ar^2$ is preferably independently a divalent linking group represented by Formula (4-1) or (4-2).

[11] The organic transistor described in [9] or [10], in which the divalent linking group represented by Formula (4-2) is preferably a divalent linking group represented by any of the following Formulae (5-1) to (5-8):

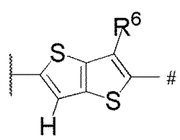

Formula (5-1)

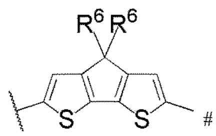

Formula (5-2)

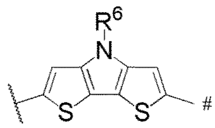

Formula (5-3)

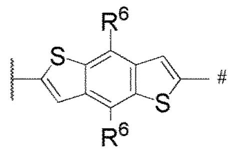

Formula (5-4)

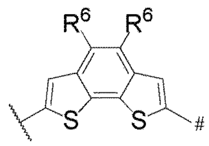

Formula (5-5)

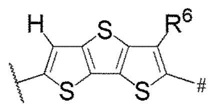

Formula (5-6)

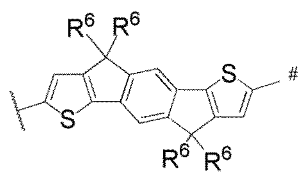

Formula (5-7)

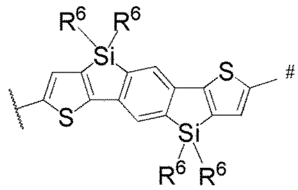

Formula (5-8)

in Formulae (5-1) to (5-8),

$R^6$ represents a hydrogen atom or a substituent, two or more $R^6$'s may be the same as or different from each other,
the wavy line represents a position of bonding to a moiety in which a 3H-pyrrol-3-one ring is condensed, and
# represents a position of bonding to $V^1$.

[12] The organic transistor described in anyone of [1] to [11], in which the compound having a repeating unit represented by Formula (1-2), or (1-3) preferably has a weight average molecular weight of equal to or greater than 30,000.

[13] A compound having a repeating unit represented by the following Formula (1-2):

Formula (1-2)

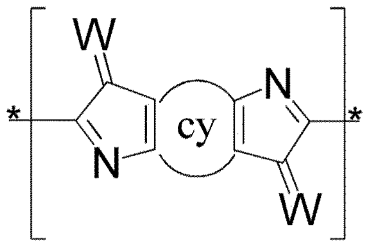

in Formula (1-2),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group, and
each $R^2$ independently represents a cyano group, an acyl group, a (per)fluoroalkyl group, or a (per)fluoroaryl group.

[14] The compound described in [13], in which in Formula (1-2), all of W's are preferably an oxygen atom.

[15] The compound described in [13] or [14], in which the compound having a repeating unit represented by Formula (1-2) is preferably a compound having a partial structure represented by the following Formula (1-2A):

Formula (1-2A)

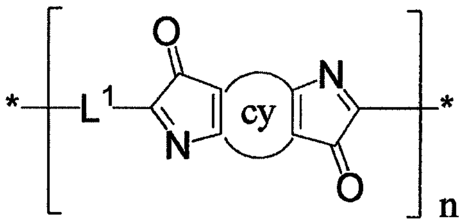

in Formula (1-2A),

Cy represents an aromatic ring or a heterocyclic aromatic ring that may have a substituent,
$L^1$ represents a single bond or a divalent linking group,
n represents an integer of equal to or greater than 2, and two or more Cy's and $L^1$'s may be the same as or different from each other.

[16] The compound described in any one of [13] to [15], in which the compound having a repeating unit represented by Formula (1-2) is preferably a compound having a partial structure represented by the following Formula (1-2B):

Formula (1-2B)

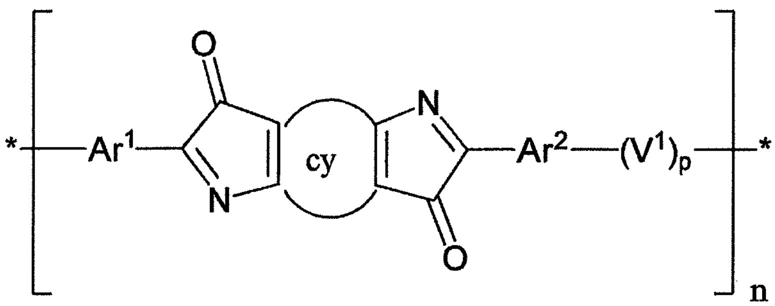

in Formula (1-2B),

Cy represents an aromatic ring or a heterocyclic aromatic ring that may have a substituent,
each of $Ar^1$ and $Ar^2$ independently represents a heteroarylene group or an arylene group,
$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more Cy's, $V^1$'s, $Ar^1$'s, and $Ar^2$'s may be the same as or different from each other.

[17] The compound described in [16], in which the partial structure represented by Formula (1-2B) is preferably a partial structure represented by any of the following Formulae (2-1) to (2-7):

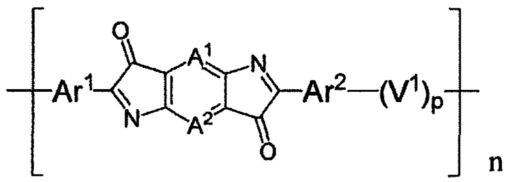

Formula (2-1)

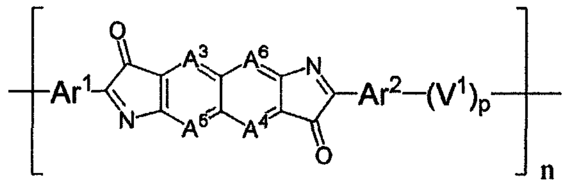

Formula (2-2)

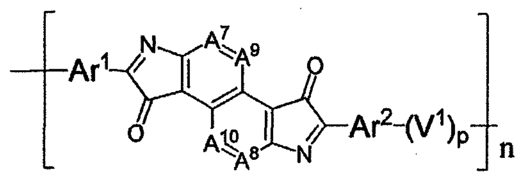

Formula (2-3)

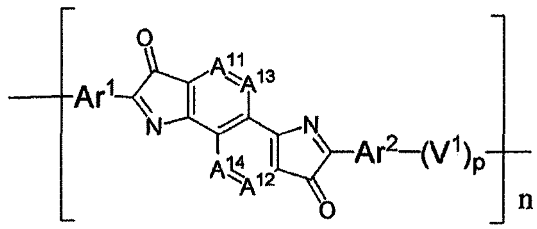

Formula (2-4)

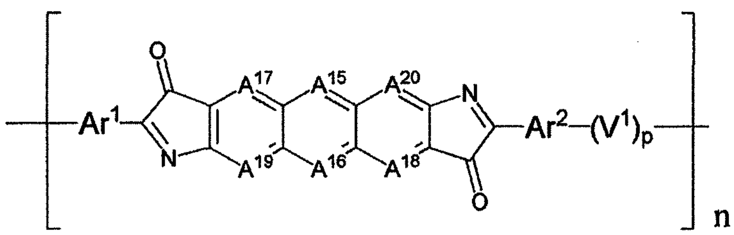

Formula (2-5)

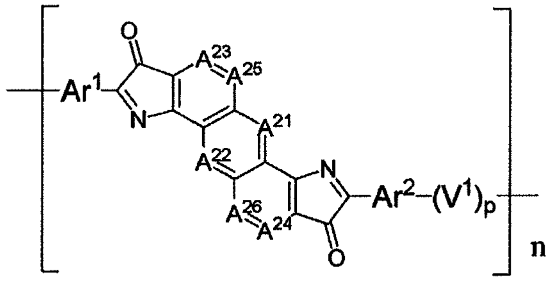

Formula (2-6)

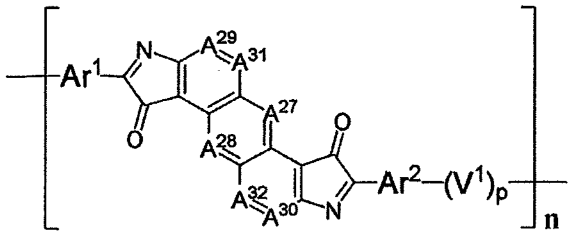

Formula (2-7)

in Formulae (2-1) to (2-7),

each of $A^1$ to $A^{32}$ independently represents $-C(R^0)-$ or a N atom,
each $R^0$ independently represents a hydrogen atom or a substituent, a plurality of $R^0$'s may be the same as or different from each other,
each of $Ar^1$ and $Ar^2$ independently represents a heteroarylene group or an arylene group,
$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more $V^1$'s, $Ar^1$'s, and $Ar^2$'s may be the same as or different from each other.

[18] The compound described in [16] or [17], in which in Formulae (1-2B) and (2-1) to (2-7), $V^1$ is preferably a single bond or a divalent linking group represented by any of the following Formulae (V-1) to (V-17):

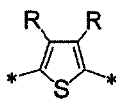
(V-1)

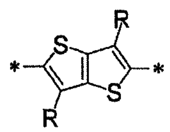
(V-2)

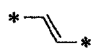
(V-3)

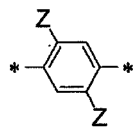
(V-4)

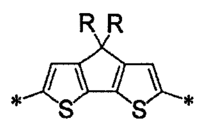
(V-5)

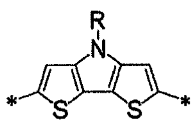
(V-6)

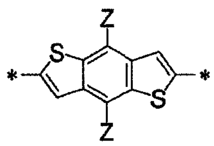
(V-7)

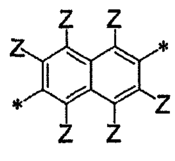
(V-8)

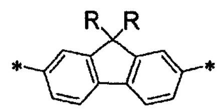
(V-9)

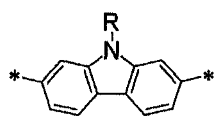
(V-10)

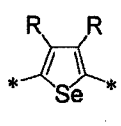
(V-11)

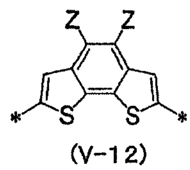
(V-12)

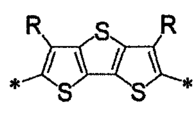
(V-13)

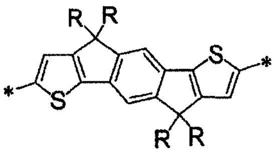
(V-14)

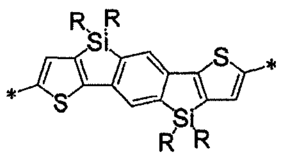
(V-15)

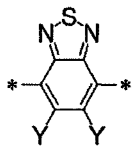
(V-16)

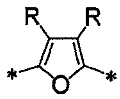
(V-17)

each R in Formulae (V-1), (V-2), (V-5), (V-6), (V-9) to (V-11), (V-13) to (V-15), and (V-17) independently represents a hydrogen atom or an alkyl group, R's adjacent to each other may form a ring by being bonded to each other,
each Z in Formulae (V-4), (V-7), (V-8), and (V-12) independently represents a hydrogen atom, an alkyl group, or an alkoxy group, Z's adjacent to each other may form a ring by being bonded to each other,
each Y in Formula (V-16) independently represents a hydrogen atom, an alkyl group, an alkoxy group, a CN group, or a F atom, and Y's adjacent to each other may form a ring by being bonded to each other.

[19] The compound described in [18], in which in Formulae (1-2B) and (2-1) to (2-7), $V^1$ is preferably a divalent linking group represented by any of Formulae (V-1) to (V-3).

[20] The compound described in any one of [16] to [19], in which in Formulae (1-2B) and (2-1) to (2-7), each of $Ar^1$ and $Ar^2$ is preferably independently a divalent linking group represented by the following Formula (4-1), (4-2), or (4-3):

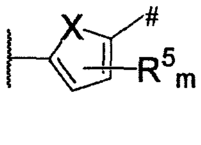
Formula (4-1)

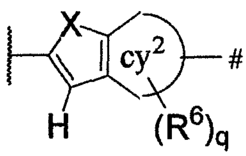
Formula (4-2)

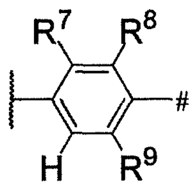
Formula (4-3)

in Formulae (4-1) to (4-3),

X represents a sulfur atom, an oxygen atom, or a Se atom,
$Cy^2$ represents a structure in which 1 to 4 rings are condensed,
each of $R^5$ to $R^9$ independently represents a hydrogen atom or a substituent,
m is 2,
q represents an integer of 0 to 6, when q is equal to or greater than 2, two or more $R^6$'s may be the same as or different from each other,
the wavy line represents a position of bonding to a moiety in which a 3H-pyrrol-3-one ring is condensed, and
# represents a position of bonding to $V^1$.

[21] The compound described in [20], in which in Formulae (1-2B) and (2-1) to (2-7), each of $Ar^1$ and $Ar^2$ is preferably independently a divalent linking group represented by Formula (4-1) or (4-2).

[22] The compound described in [20] or [21], in which the divalent linking group represented by Formula (4-2) is preferably a divalent linking group represented by any of the following Formulae (5-1) to (5-8):
(5-8):

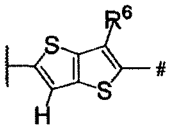
Formula (5-1)

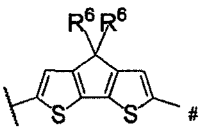
Formula (5-2)

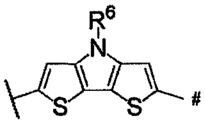
Formula (5-3)

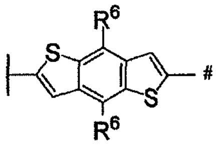
Formula (5-4)

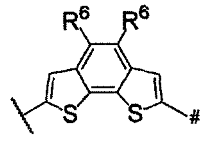

Formula (5-5)

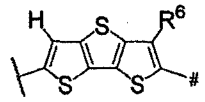

Formula (5-6)

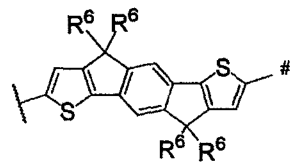

Formula (5-7)

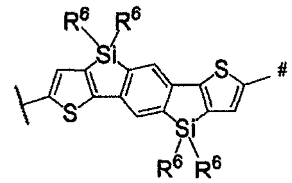

Formula (5-8)

in Formulae (5-1) to (5-8),

$R^6$ represents a hydrogen atom or a substituent, two or more $R^6$'s may be the same as or different from each other, the wavy line represents a position of bonding to a moiety in which a 3H-pyrrol-3-one ring is condensed, and # represents a position of bonding to $V^1$.

[23] The compound described in any one of [13] to [22], in which the compound having a repeating unit represented by Formula (1-2) preferably has a weight average molecular weight of equal to or greater than 30,000.

[24] An organic semiconductor material for a non-light-emitting organic semiconductor device, comprising the compound having a repeating unit represented by Formula (1-2), or (1-3) described in any one of [1] to [12].

[25] A material for an organic transistor, comprising the compound having a repeating unit represented by Formula (1-2), or (1-3) described in any one of [1] to [12].

[26] A coating solution for a non-light-emitting organic semiconductor device, comprising the compound having a repeating unit represented by Formula (1-2), or (1-3) described in anyone of [1] to [12].

[27] A coating solution for a non-light-emitting organic semiconductor device, comprising the compound having a repeating unit represented by Formula (1-2), or (1-3) described in any one of [1] to [12] and a polymer binder.

[28] An organic semiconductor film for a non-light-emitting organic semiconductor device, comprising the compound having a repeating unit represented by Formula (1-2), or (1-3) described in any one of [1] to [12].

[29] An organic semiconductor film for a non-light-emitting organic semiconductor device, comprising the compound having a repeating unit represented by Formula (1-2), or (1-3) described in any one of [1] to [12] and a polymer binder.

[30] The organic semiconductor film for a non-light-emitting organic semiconductor device described in [28] or [29] that is preferably prepared by a solution coating method.

[31] A compound represented by the following Formula (6):

Formula (6)

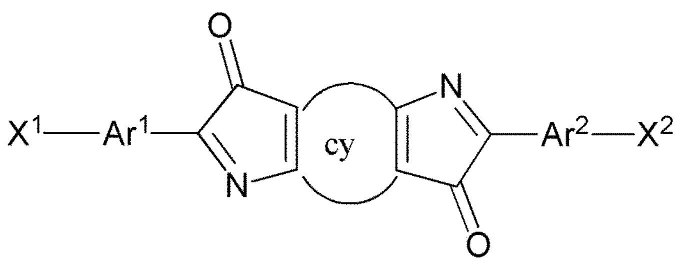

in Formula (6),

Cy represents an aromatic ring or a heterocyclic aromatic ring that may have a substituent,
each of $Ar^1$ and $Ar^2$ independently represents a heterocyclic aromatic ring or an aromatic ring, and
each of $X^1$ and $X^2$ independently represents a hydrogen atom, a halogen atom, a trifluoromethylsulfonyl group, a trialkylstannyl group, a boric acid ester group, or $-B(OH)_2$.

[32] A compound represented by the following Formula (7):

Formula (7)

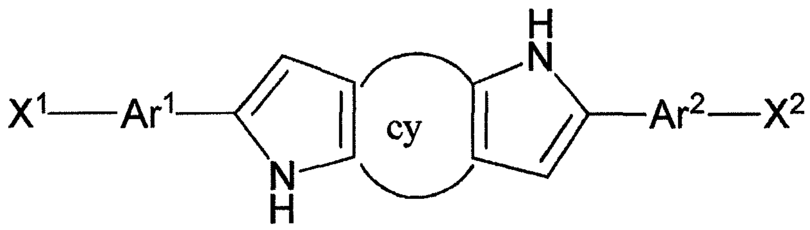

in Formula (7),

Cy represents an aromatic ring or a heterocyclic aromatic ring that may have a substituent,
each of $Ar^1$ and $Ar^2$ independently represents a heterocyclic aromatic ring or an aromatic ring, and
each of $X^1$ and $X^2$ independently represents a hydrogen atom, a halogen atom, a trifluoromethylsulfonyl group, a trialkylstannyl group, a boric acid ester group, or $-B(OH)_2$.

[33] The compound described in [31] or [32] that is preferably an intermediate compound of the compound having a repeating unit represented by Formula (1-2) described in any one of [1] to [12].

According to the present invention, it is possible to provide an organic transistor having high carrier mobility.

## BRIEF DESCRIPTION OF THE DRAWINGS

Fig. 1 is a schematic view showing a section of an exemplary structure of an organic transistor of the present invention.
Fig. 2 is a schematic view showing a section of a structure of the organic transistor manufactured as a substrate for measuring FET characteristics in examples of the present invention.

## DESCRIPTION OF THE PREFERRED EMBODIMENTS

Hereinafter, the present invention will be specifically described. The constituents described below will be explained based on representative embodiments or specific examples, but the present invention is not limited to the embodiments. In the present specification, a range of numerical values described using "to" means a range including the numerical values listed before and after "to" as a lower limit and an upper limit respectively.
In the present invention, unless otherwise specified, a hydrogen atom used in the description of each formula represents a hydrogen atom including an isotope (deuterium atom or the like). Furthermore, an atom constituting a substituent represents an atom including an isotope thereof.

[Organic transistor]

An organic transistor of the present invention contains a compound having a repeating unit represented by the following Formula (1-2), or (1-3) in a semiconductor active layer.

Formula (1-2)

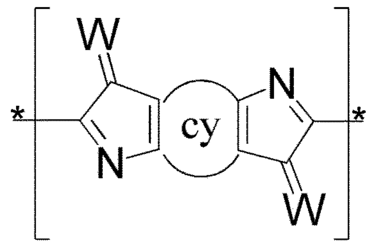

in Formula (1-2),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group, and
each $R^2$ independently represents a cyano group, an acyl group, a (per)fluoroalkyl group, or a (per)fluoroaryl group;

Formula (1-3)

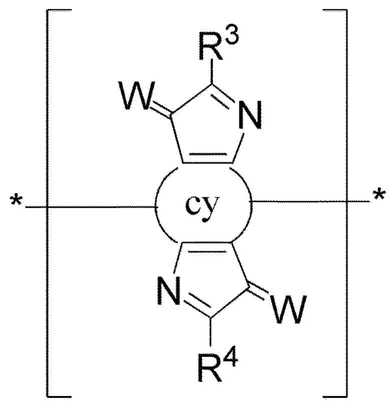

in Formula (1-3),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group,
each $R^2$ independently represents a cyano group, an acyl group, a (per)fluoroalkyl group, or a (per)fluoroaryl group, and
each of $R^3$ and $R^4$ independently represents a hydrogen atom or a monovalent substituent.

Because of containing the compound, which has a repeating unit represented by the Formula (1-2), or (1-3) described above, in a semiconductor active layer, the organic transistor of the present invention has high carrier mobility.
JP2010-535270A describes a polycyclic condensed polymer in which 5-membered rings (cyclopentadienone structure) containing a carbonyl group as an electron-withdrawing group are condensed. However, because the planarity of the polycyclic condensed polymer described in examples of JP2010-535270A deteriorates, overlapping of HOMO does not sufficiently occur, and hence sufficient transistor characteristics are not obtained (carrier mobility is low).
In contrast, the compound, which has a repeating unit represented by Formula (1-2), or (1-3), used in the semiconductor active layer of the organic transistor of the present invention is a compound having, as a repeating unit, a novel acceptor skeletal structure which is a polycyclic condensed skeletal structure containing a specific 5-membered aromatic heterocyclic ring having a nitrogen atom in a specific position. The planarity of such a compound is increased, and accordingly, overlapping of HOMO sufficiently occurs between molecules when the compound is crystallized, and the carrier mobility is improved.
Conventionally, it is known that a polycyclic condensed compound containing an aromatic heterocyclic ring is

useful as an organic EL element material. However, being useful as an organic EL element material does not mean being useful as a semiconductor material for an organic transistor, because the characteristics required for the organic compound vary between the organic EL element and the organic transistor. In the organic EL element, charges need to be transported in the film thickness direction (generally, several nanometers to hundreds of nanometers) of a general film. In contrast, in the organic transistor, charges (carriers) need to be transported a long distance between electrodes (generally, several micrometers to hundreds of micrometers) in the film plane direction, and hence extremely high carrier mobility is required. Accordingly, as the semiconductor material for an organic transistor, an organic compound showing highly ordered molecular arrangement and having high crystallinity is required. Furthermore, for the expression of high carrier mobility, the $\pi$-conjugate plane thereof is preferably upright against a substrate. On the other hand, for the organic EL element, in order to improve the luminous efficiency, an element having high luminous efficiency and uniformly emitting light in plane is required. Generally, an organic compound having high crystallinity causes luminescence defectiveness such as nonuniform in-plane electric field intensity, nonuniform luminescence, and quenching of luminescence. Therefore, as the material for an organic EL element, those having low crystallinity but having high amorphousness are desirable. Consequently, the use of the organic compound constituting the organic EL element material as an organic semiconductor material does not ensure that excellent transistor characteristics can be obtained.

Generally, a compound having high planarity and high carrier mobility is known to have low solubility. However, the compound having a repeating unit represented by Formula (1-2), or (1-3) becomes rotatable when dissolved in an organic solvent. Therefore, preferably, the compound exhibits high solubility in a general organic solvent. Accordingly, it is preferable that the compound having a repeating unit represented by Formula (1-2), or (1-3) can accomplish both the high carrier mobility and the high solubility in an organic solvent.

It is preferable that the organic transistor of the present invention using the compound having a repeating unit represented by Formula (1-2), or (1-3) shows only a slight threshold voltage shift after repeated driving. In order to reduce the threshold voltage shift after repeated driving, HOMO of the organic semiconductor material needs not to be too shallow or too deep. Furthermore, the chemical stability (particularly, resistance against air oxidation and stability against oxidation and reduction) of the organic semiconductor material, the heat stability of the film state, the high film density which makes it difficult for air or moisture to permeate the film, the film quality by which the film has small defectiveness such that charge accumulation does not easily occur, and the like are required. In addition, in a case of an oligomer or a polymer compound having a repeating unit similar to that of the compound having a repeating unit represented by Formula (1-2), or (1-3), the higher the solubility thereof in an organic solvent at the time of forming a film, the further the threshold voltage shift after repeated driving can be reduced when the oilgomer or polymer compound is used in a semiconductor active layer of an organic transistor. It is considered that because the compound having a repeating unit represented by Formula (1-2), or (1-3) can preferably satisfy the requirements described above, the threshold voltage shift after repeated driving can be reduced. That is, in the organic transistor showing only a slight threshold voltage shift after repeated driving, the semiconductor active layer has high chemical stability, high film density, and the like, and thus the organic transistor can effectively function as a transistor over a long period of time.

Hereinafter, preferred aspects of the compound having a repeating unit represented by Formula (1-2), or (1-3), the organic transistor of the present invention, and the like will be described.

<Compound having repeating unit represented by Formula (1-2), or (1-3)>

The organic transistor of the present invention contains the compound, which has a repeating unit represented by Formula (1-2), or (1-3), in a semiconductor active layer which will be described later. Among compounds having a repeating unit represented by Formula (1-2), or (1-3), the compound having a repeating unit represented by Formula (1-2) which will be described later is a novel compound and referred to as a compound of the present invention. In the organic transistor of the present invention, the compound having a repeating unit represented by Formula (1-2), or (1-3), particularly, the compound of the present invention is contained in a semiconductor active layer which will be described later. The compound having a repeating unit represented by Formula (1-2), or (1-3), particularly, the compound of the present invention can be used as a material for an organic transistor.

Hereinafter, regarding the compounds having a repeating unit represented by Formulae (1-2), or (1-3), the compound having a repeating unit represented by Formula (1-2), and the compound having a repeating unit represented by Formula (1-3) will be described in this order.

<<Compound having repeating unit represented by Formula (1-2)>>

First, the compound having a repeating unit represented by Formula (1-2) will be described.

Formula (1-2)

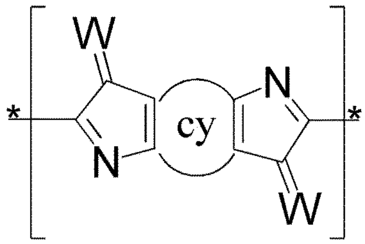

In Formula (1-2),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group, and
each $R^2$ independently represents a cyano group, an acyl group, a (per)fluoroalkyl group, or a (per)fluoroaryl group.

Cy in Formula (1-2) represents an aromatic ring or a heterocyclic aromatic ring that may have a substituent, and is preferably an aromatic ring.

Examles of the aromatic ring include a benzene ring, a naphthalene ring, an anthracene ring, a tetracene ring, a pentacene ring, a phenanthrene ring, a chrysene ring, a triphenylene ring, a pyrene ring, and the like. Among these, a benzene ring and a naphthalene ring are preferable, and a benzene ring is more preferable.

Examples of the heterocyclic aromatic ring include rings formed when C atoms forming the aforementioned aromatic rings are partially or totally substituted with a heteroatom such as an oxygen atom, a N atom, or a sulfur atom, a furan ring, a thiophene ring, a pyrrole ring, and the like. Furthermore, the aforementioned aromatic rings or heterocyclic aromatic rings may be condensed with each other or may be further condensed with an oxazole ring, a thiazole ring, an imidazole ring, a thiadiazole ring, and the like. Examples of the heterocyclic aromatic ring as a condensed heterocyclic aromatic ring include a quinoline ring, an isoquinoline ring, a naphthyridine ring, a quinoxaline ring, an acridine ring, a phenazine ring, a benzothiazole ring, a naphthobisthiadiazole ring, a thieno[3,2-b]thiophene ring, a carbazole ring, and the like. The heterocyclic aromatic ring is preferably a carbazole ring, a naphthyridine ring, a benzothiazole ring, a naphthobisthiadiazole ring, or a thiophene ring, and more preferably a naphthyridine ring, a benzothiazole ring, or a naphthobisthiadiazole ring.

In a case where Cy is an aromatic ring or a heterocyclic aromatic ring that may have a substituent, the substituent is not particularly limited, and examples of the substituent include a halogen atom, an alkyl group (including an alkyl group having 1 to 40 carbon atoms such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, or a pentadecyl group; here, the alkyl group also includes a 3,7-dimethyloctyl group, a 2-decyltetradecyl group, a 2-hexyldodecyl group, a 2-ethyloctyl group, a 2-decyltetradecyl group, a 2-butyldecyl group, a 1-octylnonyl group, a 2-ethyloctyl group, a 2-octyltetradecyl group, a 2-ethylhexyl group, a cycloalkyl group, a bicycloalkyl group, a tricycloalkyl group, and the like), an alkenyl group (including a 1-pentenyl group, a cycloalkenyl group, a bicycloalkenyl group, and the like), an alkynyl group (including a 1-pentynyl group, a trimethylsilylethynyl group, a triethylsilylethynyl group, a tri-i-propylsilylethynyl group, a 2-p-propylphenylethynyl group, and the like), an aryl group (including an aryl group having 6 to 20 carbon atoms such as a phenyl group, a naphthyl group, a p-pentylphenyl group, a 3,4-dipentylphenyl group, a p-heptoxyphenyl group, a 3,4-diheptoxyphenyl group, and the like), a hetero ring group (may be referred to as a heterocyclic group as well, including a 2-hexylfuranyl group and the like), a cyano group, a hydroxyl group, a nitro group, an acyl group (including a hexanoyl group, a benzoyl group, and the like), an alkoxy group (including a butoxy group and the like), an aryloxy group, a silyloxy group, a heterocyclic oxy group, an acyloxy group, a carbamoyloxy group, an amino group (including an anilino group), an acylamino group, an aminocarbonylamino group (including a ureide group), alkoxy- and aryloxycarbonylamino groups, alkyl- and aryl sulfonylamino groups, a mercapto group, alkyl- and arylthio groups (including a methylthio group, an octylthio group, and the like), a heterocyclic thio group, a sulfamoyl group, a sulfo group, alkyl- and aryl sulfinyl groups, alkyl- and aryl sulfonyl groups, alkyloxy- and aryloxycarbonyl groups, a carbamoyl group, aryl- and heterocyclic azo group, an imide group, a phosphino group, a phosphinyl group, a phosphinyloxy group, a phosphinylamino group, a phosphono group, a silyl group (a ditrimethylsiloxy methylbutoxy group), a hydrazino group, a ureide group, a boronic acid group ($-B(OH)_2$), a phosphate group ($-OPO(OH)_2$), a sulfate group ($-OSO_3H$), and the like.

The substituent is preferably an alkyl group having 1 to 50 carbon atoms, more preferably an alkyl group having

2 to 40 carbon atoms, and particularly preferably an alkyl group having 4 to 30 carbon atoms. The alkyl group may be a linear or branched alkyl group. As the substituent, a branched alkyl group is more preferable because the mobility and the solubility can be accomplished at the same time.

Each W in Formula (1-2) independently represents an oxygen atom, a sulfur atom, $NR^1$, or $C(R^2)_2$.

From the viewpoint of improving the carrier mobility, W is preferably an oxygen atom. All of W's are preferably the same linking group and more preferably an oxygen atom.

$R^1$ represents a hydrogen atom, an alkyl group, an alkenyl group, an alkynyl group, an aryl group, or a heteroaryl group. $R^1$ is preferably a hydrogen atom, an alkyl group, an alkenyl group, an alkynyl group, an aryl group, or a heteroaryl group, more preferably a hydrogen atom or an alkyl group, and particularly preferably a hydrogen atom.

Each $R^2$ independently represents a cyano group, an acyl group, a (per)fluoroalkyl group, or a (per)fluoroaryl group. $R^2$ is preferably a cyano group or an acyl group, and particularly preferably a cyano group.

In a case where $R^1$ represents an alkyl group, the alkyl group may be linear, branched, or cyclic.

The compound having a repeating unit represented by Formula (1-2) is preferably a compound having a partial structure represented by Formula (1-2A).

Formula (1-2A)

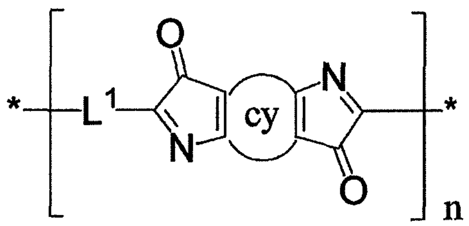

In Formula (1-2A),

Cy represents an aromatic ring or a heterocyclic aromatic ring that may have a substituent,
$L^1$ represents a single bond or a divalent linking group,
n represents an integer of equal to or greater than 2, and two or more Cy's and $L^1$'s may be the same as or different from each other.

In the compound having a partial structure represented by Formula (1-2A), an interaction occurs between the mother nucleus skeleton and a linking group (preferably a $\pi$-conjugation linking group) linked thereto, and hence the planarity is further increased. Therefore, the compound can improve the carrier mobility.

Cy in Formula (1-2A) represents an aromatic ring or a heterocyclic aromatic ring that may have a substituent. The description and preferred range of Cy in Formula (1-2A) are the same as those of Cy in Formula (1-2).

$L^1$ in Formula (1-2A) represents a single bond or a divalent linking group.

The divalent linking group is not particularly limited, and examples thereof include an arylene group, a heteroarylene group, a divalent linking group represented by any of the following Formulae (V-1) to (V-17), and the like.

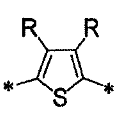
(V-1)

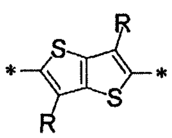
(V-2)

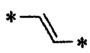
(V-3)

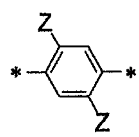
(V-4)

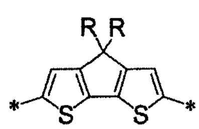
(V-5)

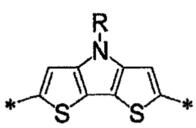
(V-6)

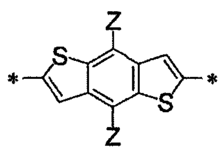
(V-7)

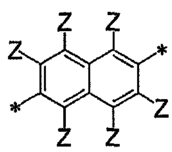
(V-8)

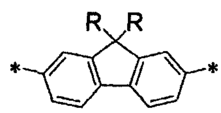
(V-9)

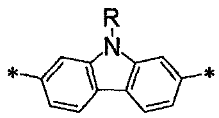

(V-10)

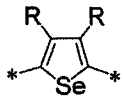

(V-11)

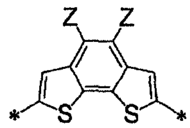

(V-12)

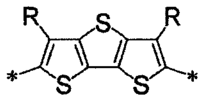

(V-13)

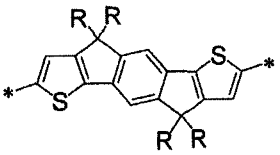

(V-14)

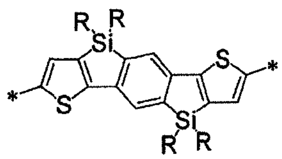

(V-15)

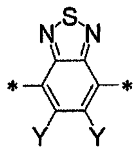

(V-16)

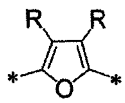

(V-17)

Each R in Formulae (V-1), (V-2), (V-5), (V-6), (V-9) to (V-11), (V-13) to (V-15), and (V-17) independently represents a hydrogen atom or an alkyl group, and R's adjacent to each other may form a ring by being bonded to each other,
each Z in Formulae (V-4), (V-7), (V-8), and (V-12) independently represents a hydrogen atom, an alkyl group, or an alkoxy group, and Z's adjacent to each other may form a ring by being bonded to each other,
each Y in Formula (V-16) independently represents a hydrogen atom, an alkyl group, an alkoxy group, a CN group, or a F atom, and Y's adjacent to each other may form a ring by being bonded to each other.

The heteroarylene group and the arylene group that can be adopted as $L^1$ are not particularly limited, and examples thereof include a heteroarylene group having 4 to 30 carbon atoms and an arylene group having 6 to 30 carbon atoms.

n in Formula (1-2A) represents an integer of equal to or greater than 2. n is preferably equal to or greater than 5, more preferably equal to or greater than 10, and particularly preferably equal to or greater than 20. The greater the value of n, the further the interaction between $\pi$-conjugated polymer chains can be improved, and hence the carrier mobility can be further improved. The upper limit of n is not particularly limited but is preferably equal to or less than 1,000 and more preferably equal to or less than 500.

The compound having a repeating unit represented by Formula (1-2) is preferably a compound having a partial structure represented by Formula (1-2B).

Formula (1-2B)

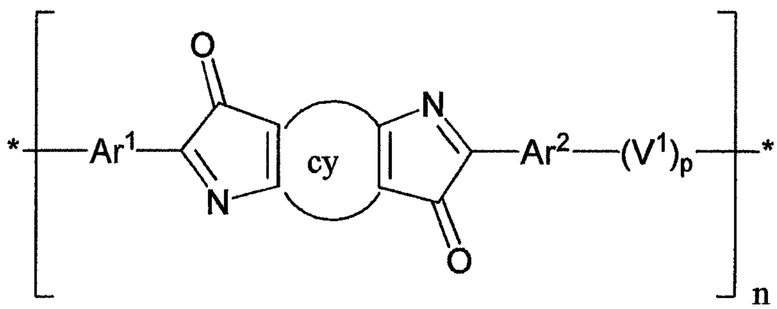

In Formula (1-2B),

Cy represents an aromatic ring or a heterocyclic aromatic ring that may have a substituent,
each of $Ar^1$ and $Ar^2$ independently represents a heteroarylene group or an arylene group,
$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more Cy's, $V^1$'s, $Ar^1$'s, and $Ar^2$'s may be the same as or different from each other.

The compound having a partial structure represented by Formula (1-2B) has a hydrogen bond with a hydrogen atom of the arylene group or the heteroarylene group adjacent to the Cy-containing mother nucleus skeleton on both

sides thereof. The hydrogen bond is maintained in the film, and hence the planarity is improved. Therefore, a distance between polymer molecules is shortened, and thus the carrier mobility can be improved. In a solvent, due to the breaking of the hydrogen bond, the compound freely rotates, and hence the solubility in an organic solvent can be improved.

Cy in Formula (1-2B) represents an aromatic ring or a heterocyclic aromatic ring that may have a substituent. The description and preferred range of Cy in Formula (1-2B) are the same as those of Cy in Formula (1-2).

Each of $Ar^1$ and $Ar^2$ in Formula (1-2B) independently represents a heteroarylene group or an arylene group.

From the viewpoint of improving the solubility, it is preferable that $Ar^1$ does not form a condensed ring by being bonded to $Ar^2$. Furthermore, from the viewpoint of improving the solubility, it is preferable that $Ar^2$ does not form a condensed ring by being bonded to $R^1$. The heteroarylene group or the arylene group that can be adopted as $Ar^1$ and $Ar^2$ is not particularly limited, and examples thereof include a heteroarylene group having 4 to 30 carbon atoms and an arylene group having 6 to 30 carbon atoms.

The heteroarylene group or the arylene group that can be adopted as $Ar^1$ and $Ar^2$ is preferably a divalent linking group represented by any of the following Formulae (4-1), (4-2), or (4-3), and more preferably a divalent linking group represented by the following Formula (4-1) or (4-2) from the viewpoint of making it difficult for twisting to occur. In addition, it is preferable that $Ar^1$ and $Ar^2$ represent the same heteroarylene group or arylene group.

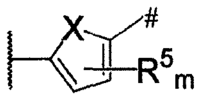

Formula (4-1)

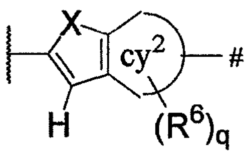

Formula (4-2)

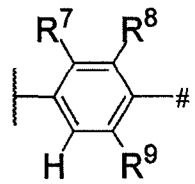

Formula (4-3)

In Formulae (4-1) to (4-3),

X represents a sulfur atom, an oxygen atom, or a Se atom,
$Cy^2$ represents a structure in which 1 to 4 rings are condensed,
each of $R^5$ to $R^9$ independently represents a hydrogen atom or a substituent,
m is 2,
q represents an integer of 0 to 6, when q is equal to or greater than 2, two or more $R^6$'s may be the same as or different from each other,
the wavy line represents a position of bonding to a moiety in which a 3H-pyrrol-3-one ring is condensed, and
# represents a position of bonding to $V^1$.

X in Formulae (4-1) and (4-2) represents a sulfur atom, an oxygen atom, or a Se atom. X is preferably a sulfur atom or a Se atom, and more preferably a sulfur atom.

In Formulae (4-1) to (4-3), each of $R^5$ to $R^9$ independently represents a hydrogen atom or a substituent. The substituent that can be adopted as $R^5$ to $R^9$ is not particularly limited, and examples thereof include a halogen atom, an alkyl group (including an alkyl group having 1 to 40 carbon atoms (preferably an alkyl group having 3 to 40 carbon atoms, and more preferably an alkyl group having 10 to 30 carbon atoms) such as a methyl group, an ethyl group, a propyl group, a butyl group, a pentyl group, a hexyl group, a heptyl group, an octyl group, a nonyl group, a decyl group, an undecyl group, a dodecyl group, a tridecyl group, a tetradecyl group, or a pentadecyl group; here, the alkyl group also includes a 3,7-dimethyloctyl group, a 2-decyltetradecyl group, a 2-hexyldodecyl group, a 2-ethyloctyl group, a 2-decyltetradecyl group, a 2-butyldecyl group, a 1-octylnonyl group, a 2-ethyloctyl group, a 2-octyltetradecyl group, and the like), an alkenyl group (including a 1-pentenyl group, a cycloalkenyl group, a bicycloalkenyl group, and the like), an alkynyl group (including a 1-pentynyl group, a trimethylsilylethynyl group, a triethylsilylethynyl group, a tri-i-propylsilylethynyl group, a 2-p-propylphenylethynyl group, and the like), an aryl group (including an aryl group having 6 to 20 carbon atoms such as a phenyl group, a naphthyl group, a p-pentylphenyl group, a 3,4-dipentylphenyl group, a p-heptoxyphenyl group, a 3,4-diheptoxyphenyl group, and the like), a hetero ring group (may be referred to as a heterocyclic group as well, including a 2-hexylfuranyl group and the like), a cyano group, a hydroxyl group, a nitro group, an acyl group (including a hexanoyl group, a benzoyl group, and the like), an aryloxy group, a silyloxy group, a heterocyclic oxy group, an acyloxy group, a carbamoyloxy group, an amino group (including an anilino group), an acylamino group, an aminocarbonylamino group (including a ureide group), an alkoxy group (having 1 to 40 carbon atoms (preferably an alkoxy group having 3 to 40 carbon atoms and more preferably an alkoxy group having 10 to 30 carbon atoms) such as a methoxy group, en ethoxy group, a propoxy group, a butoxy group, a pentoxy group, a hexyloxy group, a heptoxy group, an octoxy group,

a nonyloxy group, a decyloxy group, a 2-hexyldexyloxy group, an undecyloxy group, a dodecyloxy group, a tridecyloxy group, a tetradecyloxy group, or a pentadecyloxy group), aryloxycarbonylamino groups, alkyl- and aryl sulfonylamino groups, a mercapto group, alkyl- and arylthio groups (including a methylthio group, an octylthio group, and the like), a heterocyclic thio group, a sulfamoyl group, a sulfo group, alkyl- and aryl sulfinyl groups, alkyl- and aryl sulfonyl groups, alkyloxy- and aryloxycarbonyl groups, a carbamoyl group, aryl- and heterocyclic azo group, an imide group, a phosphino group, a phosphinyl group, a phosphinyloxy group, a phosphinylamino group, a phosphono group, a silyl group (a ditrimethylsiloxy methylbutoxy group), a hydrazino group, and other known substituents. Among these, an alkyl group and an alkoxy group are preferable.

The alkyl group that can be adopted as $R^5$ to $R^9$ is preferably an alkyl group having 3 to 40 carbon atoms, more preferably an alkyl group having 10 to 30 carbon atoms from the viewpoint of the chemical stability and the carrier transport properties, and particularly preferably an alkyl group having 15 to 30 carbon atoms. Furthermore, the alkyl group that can be adopted as $R^5$ to $R^9$ is preferably a linear or branched alkyl group, and more preferably a branched alkyl group from the viewpoint of improving the carrier mobility and the solubility in a solvent without deteriorating the intramolecular hydrogen bonding properties.

The alkoxy group that can be adopted as $R^5$ to $R^9$ is preferably an alkoxy group having 3 to 40 carbon atoms, more preferably an alkoxy group having 10 to 30 carbon atoms from the viewpoint of the chemical stability and the carrier transport properties, and particularly preferably an alkoxy group having 15 to 30 carbon atoms. In addition, the alkoxy group that can be adopted as $R^5$ to $R^9$ is preferably a linear or branched alkoxy group, and more preferably a branched alkoxy group from the viewpoint of improving the carrier mobility and the solubility in a solvent without deteriorating the intramolecular hydrogen bonding properties.

The above substituents may further have the substituents described above.

Moreover, the above substituents may further have a group derived from a polymerizable group.

The divalent linking group represented by Formula (4-1) is more preferably a divalent linking group represented by the following Formula (4-1A).

Formula (4-1A)

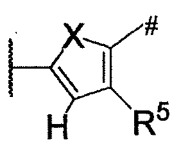

In Formula (4-1A),

X represents a sulfur atom, an oxygen atom, or a Se atom,
$R^5$ represents a hydrogen atom or a substituent,
the wavy line represents a position of bonding to a moiety in which a 3H-pyrrol-3-one ring is condensed, and
# represents a position of bonding to $V^1$.

The preferred range of X and $R^5$ in Formula (4-1A) is the same as the preferred range of X and $R^5$ in Formula (4-1).

In Formula (4-2), q represents an integer of 0 to 6. q is preferably an integer of 0 to 3, more preferably an integer of 0 to 2, and even more preferably an integer of 0 or 1.

$Cy^2$ in Formula (4-2) represents a structure in which 1 to 4 rings are condensed. $Cy^2$ is preferably a structure in which 1 to 4 aromatic rings or heterocyclic aromatic rings are condensed, more preferably a structure in which 1 to 4 aromatic rings having 6 to 10 carbon atoms or 1 to 4 heterocyclic aromatic rings having 4 to 6 carbon atoms are condensed, and particularly preferably a structure in which 1 to 4 benzene rings or thiophene rings are condensed.

The divalent linking group represented by Formula (4-2) is preferably a divalent linking group represented by any of the following Formulae (5-1) to (5-8), and more preferably a divalent linking group represented by Formula (5-1).

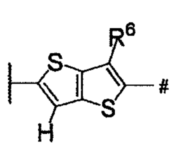

Formula (5-1)

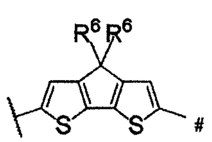

Formula (5-2)

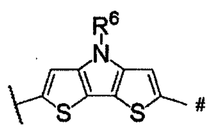

Formula (5-3)

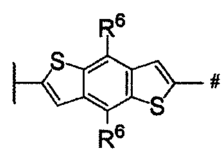

Formula (5-4)

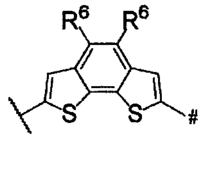

Formula (5-5)

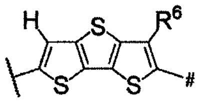

Formula (5-6)

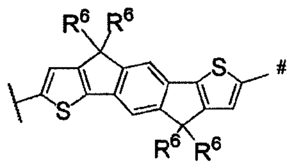

Formula (5-7)

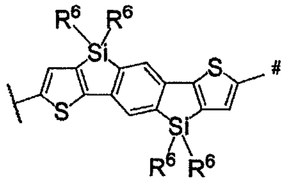

Formula (5-8)

In Formulae (5-1) to (5-8),

$R^6$ represents a hydrogen atom or a substituent, two or more $R^6$'s may be the same as or different from each other, the wavy line represents a position of bonding to a moiety in which a 3H-pyrrol-3-one ring is condensed, and # represents a position of bonding to $V^1$.

In Formulae (5-1) to (5-8), each $R^6$ independently represents a hydrogen atom or a substituent, and two or more $R^6$'s may be the same as or different from each other. Examples of the substituent that can be adopted as $R^6$ include those exemplified above as the substituent that can be adopted as $R^5$ to $R^9$ in the Formulae (4-1) to (4-3) described above, and the preferred range thereof is also the same.

$V^1$ in Formula (1-2B) represents a single bond or a divalent linking group. From the viewpoint of improving the solubility, it is preferable that $V^1$ does not form a condensed ring with $Ar^1$ or $Ar^2$. The divalent linking group that can be adopted as $V^1$ is not particularly limited, but is preferably represented by any of the following Formulae (V-1) to (V-17).

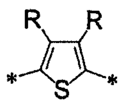

(V-1)

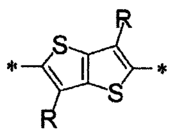

(V-2)

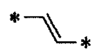

(V-3)

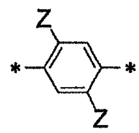

(V-4)

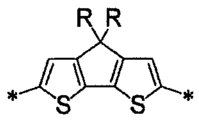

(V-5)

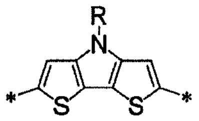

(V-6)

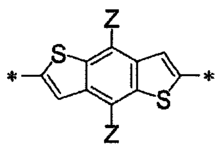

(V-7)

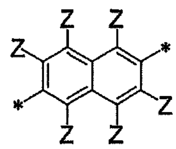

(V-8)

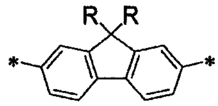

(V-9)

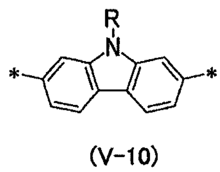

(V-10)

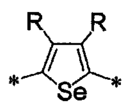

(V-11)

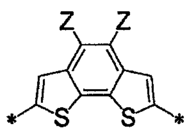

(V-12)

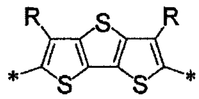

(V-13)

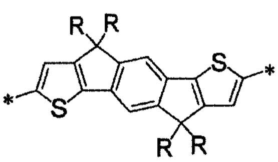

(V-14)

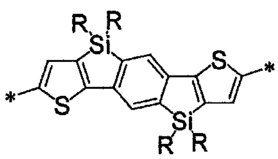

(V-15)

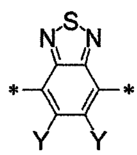

(V-16)

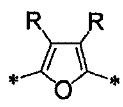

(V-17)

Each R in Formulae (V-1), (V-2), (V-5), (V-6), (V-9) to (V-11), (V-13) to (V-15), and (V-17) independently represents a hydrogen atom or an alkyl group, R's adjacent to each other may form a ring by being bonded to each other, each Z in Formulae (V-4), (V-7), (V-8), and (V-12) independently represents a hydrogen atom, an alkyl group, or an alkoxy group, Z's adjacent to each other may form a ring by being bonded to each other,

each Y in Formula (V-16) independently represents a hydrogen atom, an alkyl group, an alkoxy group, a CN group, or a F atom, and Y's adjacent to each other may form a ring by being bonded to each other.

Each R in Formulae (V-1), (V-2), (V-5), (V-6), (V-9) to (V-11), (V-13) to (V-15), and (V-17) independently represents a hydrogen atom or an alkyl group, and R's adjacent to each other may form a ring by being bonded to each other. Examples of the alkyl group that can be adopted as R include the alkyl group that can be adopted as $R^5$ to $R^9$ in the Formulae (4-1) to (4-3) described above. The preferred range of the alkyl group that can be adopted as R is the same as the preferred range of the alkyl group that can be adopted as $R^5$ to $R^9$.

Each Z in Formulae (V-4), (V-7), (V-8), and (V-12) independently represents a hydrogen atom, an alkyl group, or an alkoxy group, and Z's adjacent to each other may form a ring by being bonded to each other. Examples of the alkyl group or the alkoxy group that can be adopted as Z include the alkyl group and the alkoxy group that can be adopted as $R^5$ to $R^9$ in the Formulae (4-1) to (4-3) described above. The preferred range of the alkyl group and the alkoxy group that can be adopted as Z is the same as the preferred range of the alkyl group and the alkoxy group that can be adopted as $R^5$ to $R^9$.

Each Y in Formula (V-16) independently represents a hydrogen atom, an alkyl group, an alkoxy group, a CN group, or a F atom, and Y's adjacent to each other may form a ring by being bonded to each other. Y is preferably an alkyl group or an alkoxy group. Examples of the alkyl group and the alkoxy group that can be adopted as Y include the alkyl group and the alkoxy group exemplified above as the substituent that can be adopted as $R^5$ to $R^9$ in the Formulae (4-1) to (4-3) described above, and the preferred range thereof is also the same.

Among the divalent linking groups represented by Formulae (V-1) to (V-17), divalent linking groups represented by Formulae (V-1) to (V-8) and (V-11) to (V-15) are preferable, and divalent linking groups represented by Formulae (V-1) to (V-3) are more preferable.

p in Formula (1-2B) represents an integer of 1 to 6. When p is equal to or greater than 2, two or more $V^1$'s may be the same as or different from each other, p is more preferably 1 to 5, and particularly preferably 1 to 3.

n in Formula (1-2B) represents an integer of equal to or greater than 2. Two or more Cy's, $V^1$'s, $Ar^1$'s, and $Ar^2$'s may be the same as or different from each other. n is preferably equal to or greater than 5, more preferably equal to or greater than 10, and particularly preferably equal to or greater than 20. The greater the value of n, the further the interaction between $\pi$-conjugated polymer chains can be improved, and hence the carrier mobility can be further improved. The upper limit of n is not particularly limited, but is preferably equal to or less than 1,000 and more preferably equal to or less than 500.

Formula (1-2B) particularly preferably represents a compound having a partial structure represented by any of the following Formulae (2-1) to (2-7) from the viewpoint of high carrier mobility and high solubility in a solvent, and more preferably represents a compound having a partial structure represented by any of Formulae (2-1) to (2-4) from the viewpoint of high solubility in a solvent.

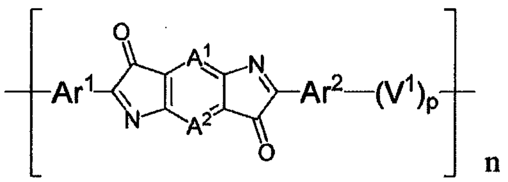

Formula (2-1)

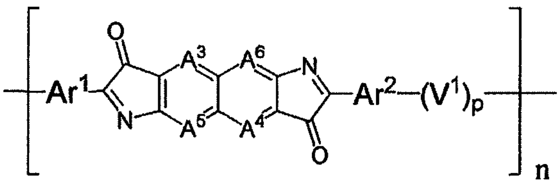

Formula (2-2)

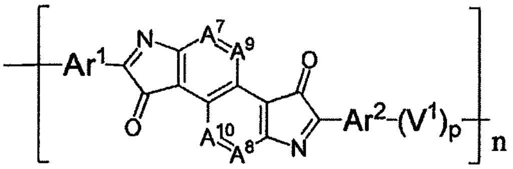

Formula (2-3)

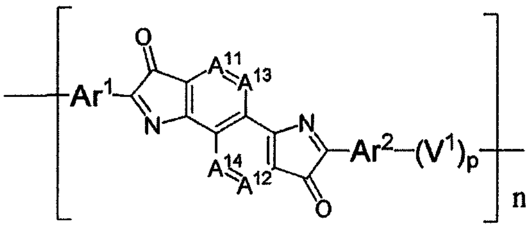

Formula (2-4)

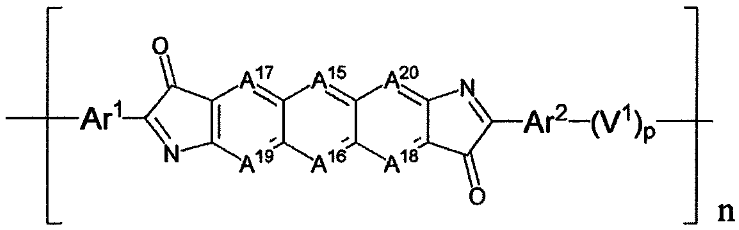

Formula (2-5)

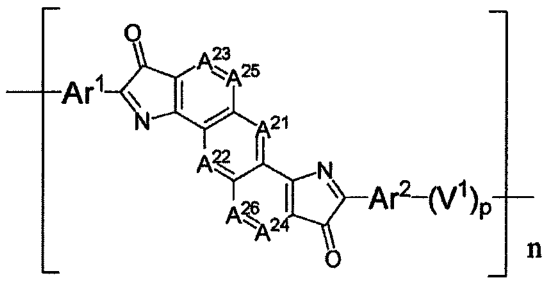

Formula (2-6)

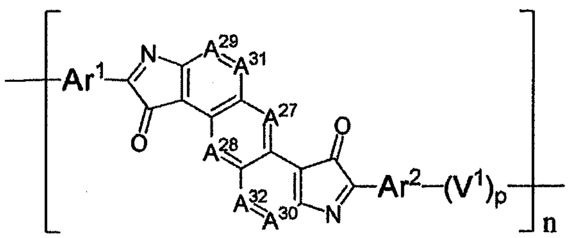

Formula (2-7)

In Formulae (2-1) to (2-7),

each of $A^1$ to $A^{32}$ independently represents -C($R^0$)- or a N atom,
each $R^0$ independently represents a hydrogen atom or a substituent, a plurality of $R^0$'s may be the same as or different from each other,
each of $Ar^1$ and $Ar^2$ independently represents a heteroarylene group or an arylene group,
$V^1$ represents a single bond or a divalent linking group,
p represents 1 to 6, when p is equal to or greater than 2, two or more $V^1$'s may be the same as or different from each other,
n represents an integer of equal to or greater than 2, and two or more $V^1$'s, $Ar^1$'s, and $Ar^2$'s may be the same as or different from each other.

Each of $A^1$ to $A^{32}$ in Formulae (2-1) to (2-7) independently represents -C($R^0$)- or a N atom.

Each $R^0$ independently represents a hydrogen atom or a substituent, and a plurality of $R^0$'s may be the same as or different from each other. Examples of the substituent include the same substituent as described above that Cy in the Formula (1-2) described above can have in a case where Cy represents an aromatic ring or a heterocyclic aromatic ring that may have a substituent.

Each of $Ar^1$ and $Ar^2$ in Formulae (2-1) to (2-7) independently represents a heteroarylene group or an arylene group. The preferred range of $Ar^1$ and $Ar^2$ is the same as the range of $Ar^1$ and $Ar^2$ in the Formula (1-2B) described above.

$V^1$ in Formulae (2-1) to (2-7) represents a single bond or a divalent linking group. The preferred range of $V^1$ is the same as the range of $V^1$ in Formula (1-2B) described above.

p in Formulae (2-1) to (2-7) represents 1 to 6. The preferred range of p is the same as the range of p in the Formula (1-2B) described above.

n in Formulae (2-1) to (2-7) represents an integer of equal to or greater than 2. The preferred range of n is the same as the range of n in the Formula (1-2B) described above.

<<Compound having repeating unit represented by Formula (1-3)>>

Next, the compound having a repeating unit represented by Formula (1-3) will be described.

Formula (1-3)

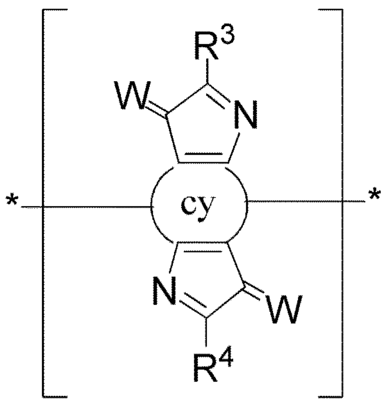

In Formula (1-3),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group,
each $R^2$ independently represents a cyano group, an acyl group, a (per)fluoroalkyl group, or a (per)fluoroaryl group, and
each of $R^3$ and $R^4$ independently represents a hydrogen atom or a monovalent substituent.

Each of Cy, W, $R^1$, and $R^2$ in Formula (1-3) has the same definition as each of Cy, W, $R^1$, and $R^2$ in Formula (1-2), and the preferred range thereof is also the same.

Each of $R^3$ and $R^4$ is independently a hydrogen atom or a monovalent substituent.

Examples of the monovalent substituent represented by $R^3$ and $R^4$ include the same substituents as described above that Cy in the Formula (1-2) described above can have in a case where Cy represents an aromatic ring or a heterocyclic aromatic ring that may have a substituent. Each of $R^3$ and $R^4$ is preferably a hydrogen atom, an alkyl group, an alkenyl group, an alkynyl group, an aryl group, or a heteroaryl group, and more preferably a hydrogen atom.

Specific examples of the compound having a repeating unit represented by the Formula (1-2), or (1-3) will be shown below. However, the compound having a repeating unit represented by Formula (1-2), or (1-3) that can be used in the present invention is not limited to the specific examples. In the following specific examples of the compound, a repetition number n will not be shown, and only the repeating unit will be described.

First, specific examples of the compound having a repeating unit represented by Formula (1-2) will be shown.

Formula (1-2')

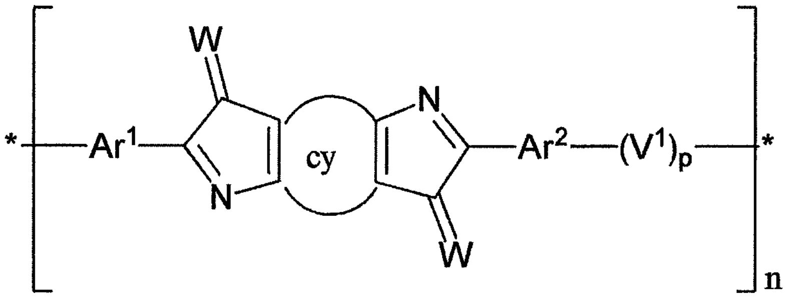

W, $Ar^1$, $Ar^2$, $V^1$, and p in Formula (1-2') are as described in the following table. In the present specification, in a case where $V^1$ represents a single bond, a definition of p = 1 is given.

[Table 1]

| | W | Cy (In the following formulae, * represents a moiety linked to a N atom of a 3H-pyrrole ring, and + represents a moiety linked to a C atom of a C=W group.) | | Ar$^1$ (In the following formulae, a wavy line represents a moiety linked to a 3H-pyrrole ring, and # represents a moiety linked to V$^1$.) | Ar$^2$ (In the following formulae, a wavy line represents a moiety linked to a 3H-pyrrole ring, and # represents a moiety linked to V$^1$.) | V$^1$ (In the following formulae, # represents a moiety linked to Ar$^1$.) | p | Weight average molecular weight |
|---|---|---|---|---|---|---|---|---|
| Compound 1 | O | 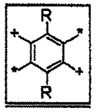 | R represents a 2-ethylhexyl group. | 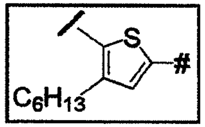 | 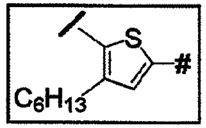 | Single bond | 1 | 44,000 |
| Compound 2 | O | 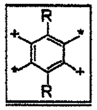 | R represents a 2-ethylhexyl group. | 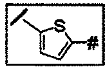 | 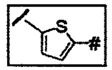 | Single bond | 1 | 23,000 |
| Compound 3 | O | 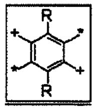 | R represents a 2-ethythexyl group. | 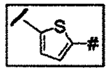 | 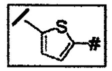 | 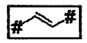 | 1 | 33,000 |
| Compound 4 | O | 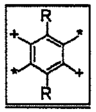 | R represents a 2-ethylhexyl group. | 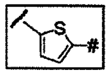 | 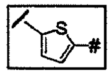 | 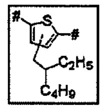 | 2 | 16,000 |
| Compound 5 | O | 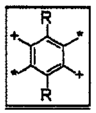 | R represents a 2-ethylhexyl group. | 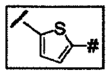 | 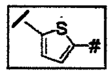 | 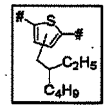 | 2 | 31,000 |
| Compound 6 | O | 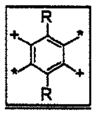 | R represents a 3,7-dimethyloctyl group. | 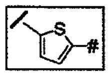 | 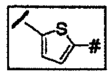 | 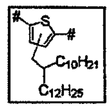 | 2 | 39,000 |
| Compound 7 | O | 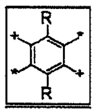 | R represents a 2-decyltetradecyl group. | 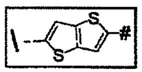 | 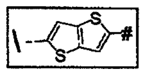 | Single bond | 1 | 36,000 |

(continued)

| | W | Cy (In the following formulae, * represents a moiety linked to a N atom of a 3H-pyrrole ring, and + represents a moiety linked to a C atom of a C=W group.) | Ar¹ (In the following formulae, a wavy line represents a moiety linked to a 3H-pyrrole ring, and # represents a moiety linked to V¹.) | Ar² (In the following formulae, a wavy line represents a moiety linked to a 3H-pyrrole ring, and # represents a moiety linked to V¹.) | V¹ (In the following formulae, # represents a moiety linked to Ar¹.) | p | Weight average molecular weight |
|---|---|---|---|---|---|---|---|
| Compound 8 | O | 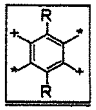 R represents a 2-ethylhexyl group. | 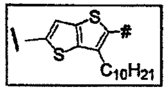 | 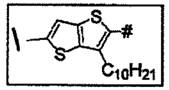 | Single bond | 1 | 54,000 |

[Table 2]

| | W | Cy (In the following formulae, * represents a moiety linked to a N atom of a 3H-pyrrole ring, and + represents a moiety linked to a C atom of a C=W group.) | Ar1 (In the following formulae, a wavy line represents a moiety linked to a 3H-pyrrole ring, and # represents a moiety linked to $V^1$.) | Ar2 (In the following formulae, a wavy line represents a moiety linked to a 3H-pyrrole ring, and # represents a moiety linked to $V^1$.) | $V^1$ (In the following formulae, # represents a moiety linked to $Ar^1$.) | P | Weight average molecular weight |
|---|---|---|---|---|---|---|---|
| Compound 9 | NH | 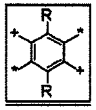 R represents a 2-ethylhexyl group. | 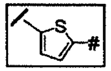 | 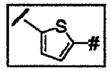 | Single bond | 1 | 23,000 |
| Compound 10 | S | 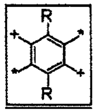 R represents a 2-ethylhexyl group. | 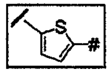 | 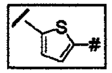 | Single bond | 1 | 21,000 |
| Compound 11 | C $(CN)_2$ | 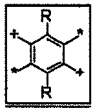 R represents a 2-ethylhexyl group. | 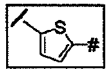 | 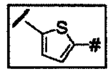 | Single bond | 1 | 29,000 |
| Compound 12 | O | 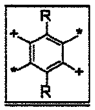 R represents a 2-ethylhexyl group. | 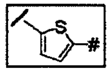 | 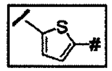 | 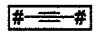 | 1 | 30,000 |
| Compound 13 | O | 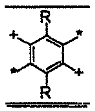 R represents a 2-ethylhexyl group. | 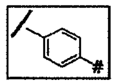 | 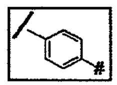 | 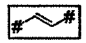 | 1 | 40,000 |
| Compound 14 | O | 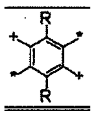 R represents a 2-ethylhexyl group. | 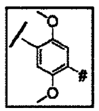 | 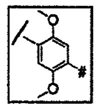 | 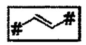 | 1 | 40,000 |
| Compound 15 | O | 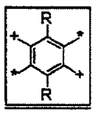 R represents a 2-ethylhexyl group. | 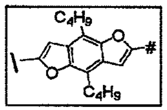 | 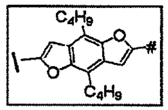 | 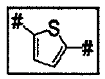 | 2 | 47,000 |

(continued)

| | W | Cy (In the following formulae, * represents a moiety linked to a N atom of a 3H-pyrrole ring, and + represents a moiety linked to a C atom of a C=W group.) | Ar[1] (In the following formulae, a wavy line represents a moiety linked to a 3H-pyrrole ring, and # represents a moiety linked to V[1].) | Ar[2] (In the following formulae, a wavy line represents a moiety linked to a 3H-pyrrole ring, and # represents a moiety linked to V[1].) | V[1] (In the following formulae, # represents a moiety linked to Ar[1].) | P | Weight average molecular weight |
|---|---|---|---|---|---|---|---|
| Compound 16 | O | 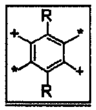 R represents a 2-decyltetradecyl group. | 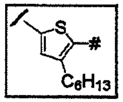 | 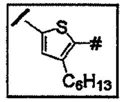 | 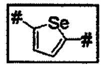 | 1 | 29,000 |

[Table 3]

| | W | Cy (In the following formulae, * represents a moiety linked to a N atom of a 3H-pyrrole ring, and + represents a moiety linked to a C atom of a C=W group.) | Ar¹ (In the following formulae, a wavy line represents a moiety linked to a 3H-pyrrole ring, and # represents a moiety linked to V¹.) | Ar² (In the following formulae, a wavy line represents a moiety linked to a 3H-pyrrole ring, and # represents a moiety linked to V¹.) | V¹ (In the following formulae, # represents a moiety linked to Ar¹.) | p | Weight average molecular weight |
|---|---|---|---|---|---|---|---|
| Compound 17 | O | 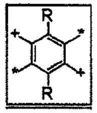 R represents a 2-decyltetradecyl group. | 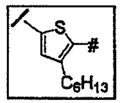 | 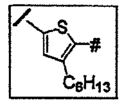 | 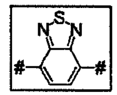 | 1 | 33,000 |
| Compound 18 | O | 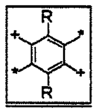 R represents a n-butyl group. | 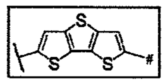 | 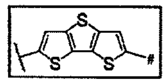 | 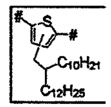 | 2 | 31,000 |
| Compound 19 | O | 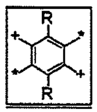 R represents a n-butyl group. | 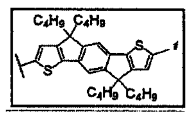 | 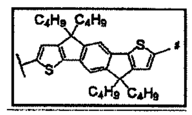 | 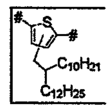 | 2 | 35,000 |
| Compound 20 | O | 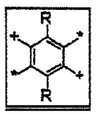 R represents a n-butyl group. | 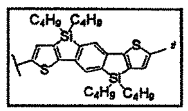 | 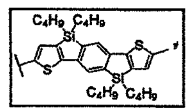 | 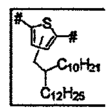 | 2 | 30,000 |
| Compound 21 | O | 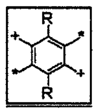 R represents a 2-decyltetradecyl group. | 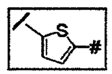 | 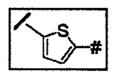 | 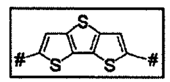 | 1 | 27,000 |
| Compound 22 | O | 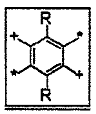 R represents a 2-decyltetradecyl group. | 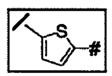 | 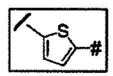 | 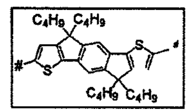 | 1 | 23,000 |
| Compound 23 | O | 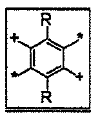 R represents a 2-decyltetradecyl group. | 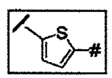 | 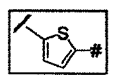 | 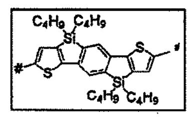 | 1 | 28,000 |

(continued)

| | W | Cy (In the following formulae, * represents a moiety linked to a N atom of a 3H-pyrrole ring, and + represents a moiety linked to a C atom of a C=W group.) | Ar[1] (In the following formulae, a wavy line represents a moiety linked to a 3H-pyrrole ring, and # represents a moiety linked to V[1].) | Ar[2] (In the following formulae, a wavy line represents a moiety linked to a 3H-pyrrole ring, and # represents a moiety linked to V[1].) | V[1] (In the following formulae, # represents a moiety linked to Ar[1].) | p | Weight average molecular weight |
|---|---|---|---|---|---|---|---|
| Compound 24 | O | 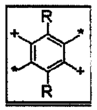 R represents a 2-decyltetradecyl group. | 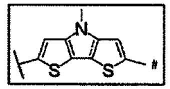 | 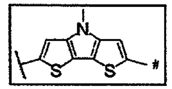 | 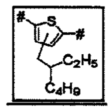 | 2 | 28,000 |

[Table 4]

| | W | Cy (In the following formulae, * represents a moiety linked to a N atom of a 3H-pyrrole ring, and + represents a moiety linked to a C atom of a C=W group.) | Ar$^1$ (In the following formulae, a wavy line represents a moiety linked to a 3H-pyrrole ring, and # represents a moiety linked to V$^1$.) | Ar$^2$ (In the following formulae, a wavy line represents a moiety linked to a 3H-pyrrole ring, and # represents a moiety linked to V$^1$.) | V$^1$ (In the following formulae, # represents a moiety linked to Ar$^1$.) | p | Weight average molecular weight |
|---|---|---|---|---|---|---|---|
| Compound 25 | O | 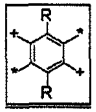 R represents a fluorine atom. | 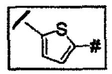 | 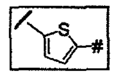 | 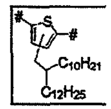 | 2 | 31,000 |
| Compound 26 | O | 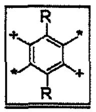 R represents a hydrogen atom. | 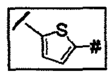 | 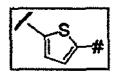 | 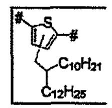 | 2 | 34,000 |
| Compound 27 | O | 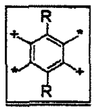 R represents a 3,7-dimethyloctyl group. | 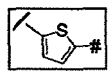 | 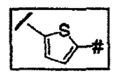 | 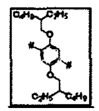 | 1 | 24,000 |
| Compound 28 | O | 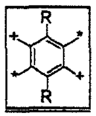 R represents a 2-decyltetradecyl group. | 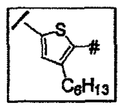 | 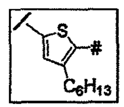 | 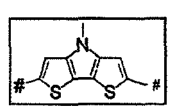 | 1 | 34,000 |
| Compound 29 | O | 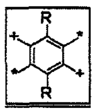 R represents a 2-ethylhexyl group. | 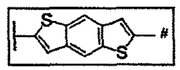 | 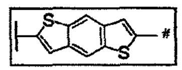 | 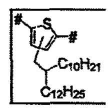 | 2 | 45,000 |
| Compound 30 | O | 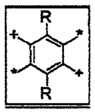 R represents a 2-ethylhexyl group. | 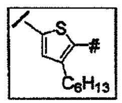 | 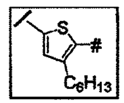 | 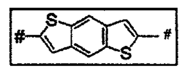 | 2 | 35,000 |
| Compound 31 | O | 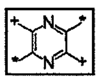 | 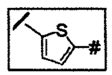 | 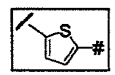 | 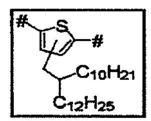 | 2 | 39,000 |

(continued)

| | W | Cy (In the following formulae, * represents a moiety linked to a N atom of a 3H-pyrrole ring, and + represents a moiety linked to a C atom of a C=W group.) | $Ar^1$ (In the following formulae, a wavy line represents a moiety linked to a 3H-pyrrole ring, and # represents a moiety linked to $V^1$.) | $Ar^2$ (In the following formulae, a wavy line represents a moiety linked to a 3H-pyrrole ring, and # represents a moiety linked to $V^1$.) | $V^1$ (In the following formulae, # represents a moiety linked to $Ar^1$.) | p | Weight average molecular weight |
|---|---|---|---|---|---|---|---|
| Compound 32 | O | 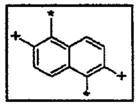 | 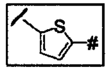 | 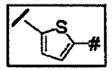 | 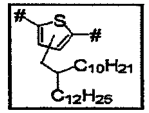 | 2 | 39,000 |

[Table 5]

| | W | Cy (In the following formulae, * represents a moiety linked to a N atom of a 3H-pyrrole ring, and + represents a moiety linked to a C atom of a C=W group.) | $Ar^1$ (In the following formulae, a wavy line represents a moiety linked to a 3H-pyrrole ring, and # represents a moiety linked to $V^1$.) | $Ar^2$ (In the following formulae, a wavy line represents a moiety linked to a 3H-pyrrole ring, and # represents a moiety linked to $V^1$.) | $V^1$ (In the following formulae, # represents a moiety linked to $Ar^1$.) | p | Weight average molecular weight |
|---|---|---|---|---|---|---|---|
| Compound 33 | O | 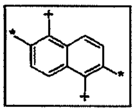 | 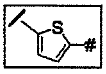 | 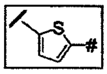 | 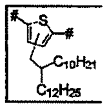 | 2 | 44,000 |
| Compound 34 | O | 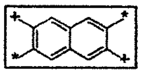 | 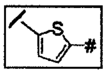 | 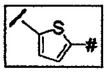 | 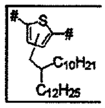 | 2 | 47,000 |
| Compound 35 | O | 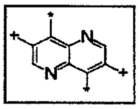 | 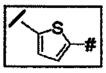 | 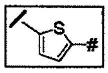 | 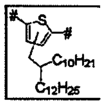 | 2 | 39,000 |
| Compound 36 | O | 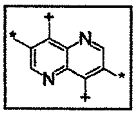 | 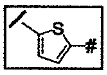 | 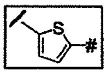 | 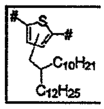 | 2 | 44,000 |
| Compound 37 | O | 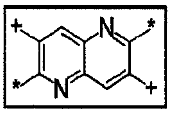 | 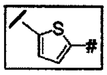 | 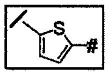 | 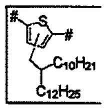 | 2 | 31,000 |
| Compound 38 | O | 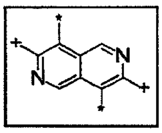 | 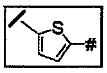 | 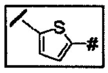 | 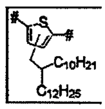 | 2 | 39,000 |
| Compound 39 | O | 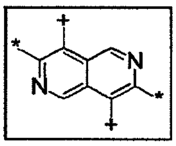 | 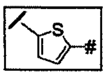 | 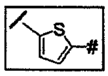 | 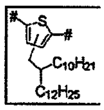 | 2 | 44,000 |
| Compound 40 | O | 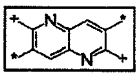 | 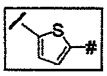 | 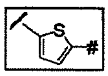 | 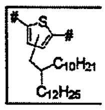 | 2 | 31,000 |

[Table 6]

| | W | Cy (In the following formulae, * represents a moiety linked to a N atom of a 3H-pyrrole ring, and + represents a moiety linked to a C atom of a C=W group.) | | Ar[1] (In the following formulae, a wavy line represents a moiety linked to a 3H-pyrrole ring, and# represents a moiety linked to $V^1$.) | $Ar^2$ (In the following formulae, a wavy line represents a moiety linked to a 3H-pyrrole ring, and # represents a moiety linked to $V^1$.) | $V^1$ (In the following formulae, # represents a moiety linked to $Ar^1$.) | p | Weight average molecular weight |
|---|---|---|---|---|---|---|---|---|
| Compound 41 | O | 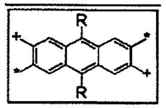 | R represents a 3,7-dimethyloctyl group. | 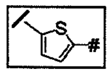 | 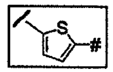 | 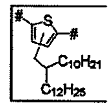 | 2 | 31,000 |
| Compound 42 | O | 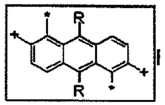 | R represents a 3,7-dimethyloctyl group. | 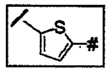 | 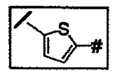 | 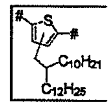 | 2 | 49,000 |
| Compound 43 | O | 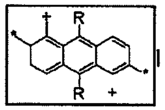 | R represents a 3,7-dimethyloctyl group. | 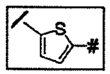 | 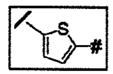 | 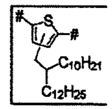 | 2 | 39,000 |
| Compound 44 | O | 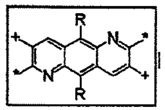 | R represents a 3,7-dimethyloctyl group. | 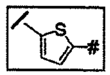 | 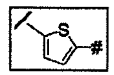 | 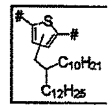 | 2 | 36,000 |
| Compound 45 | O | 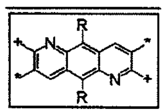 | R represents a 3,7-dimethyloctyl group. | 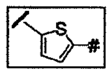 | 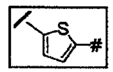 | 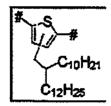 | 2 | 40,000 |
| Compound 46 | O | 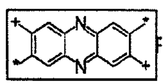 | R represents a 3,7-dimethyloctyl group. | 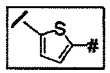 | 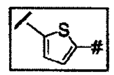 | 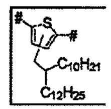 | 2 | 45,000 |
| Compound 47 | O | 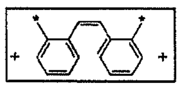 | | 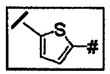 | 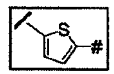 | 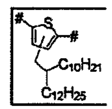 | 2 | 27,000 |

(continued)

| | W | Cy (In the following formulae, * represents a moiety linked to a N atom of a 3H-pyrrole ring, and + represents a moiety linked to a C atom of a C=W group.) | $Ar^1$ (In the following formulae, a wavy line represents a moiety linked to a 3H-pyrrole ring, and# represents a moiety linked to $V^1$.) | $Ar^2$ (In the following formulae, a wavy line represents a moiety linked to a 3H-pyrrole ring, and # represents a moiety linked to $V^1$.) | $V^1$ (In the following formulae, # represents a moiety linked to $Ar^1$.) | p | Weight average molecular weight |
|---|---|---|---|---|---|---|---|
| Compound 48 | O | 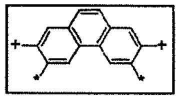 | 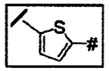 | 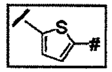 | 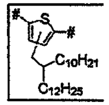 | 2 | 28,000 |

[Table 7]

| | W | Cy (In the following formulae, * represents a moiety linked to a N atom of a 3H-pyrrole ring, and + represents a moiety linked to a C atom of a C=W group.) | Ar[1] (In the following formulae, a wavy line represents a moiety linked to a 3H-pyrrole ring, and # represents a moiety linked to V[1].) | Ar[2] (In the following formulae, a wavy line represents a moiety linked to a 3H-pyrrole ring, and # represents a moiety linked to V[1].) | V[1] (In the following formulae, # represents a moiety linked to Ar[1].) | p | Weight average molecular weight |
|---|---|---|---|---|---|---|---|
| Compound 49 | O | 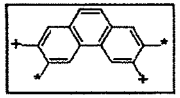 | 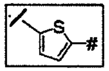 | 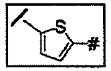 | 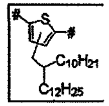 | 2 | 39,000 |
| Compound 50 | O | 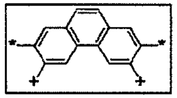 | 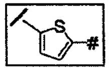 | 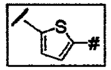 | 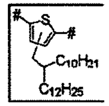 | 2 | 31,000 |
| Compound 51 | O | 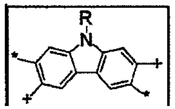 R represents a 2-decyltetradecyl group. | 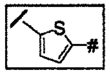 | 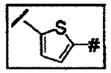 | Single bond | 1 | 31,000 |
| Compound 52 | O | 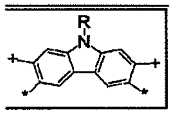 R represents a 2-decyltetradecyl group. | 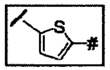 | 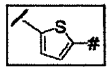 | Single bond | 1 | 33,000 |
| Compound 53 | O | 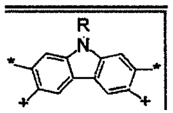 R represents a 2-decyltetradecyl group. | 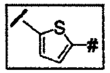 | 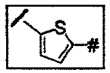 | Single bond | 1 | 34,000 |
| Compound 54 | O | 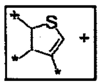 | 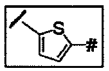 | 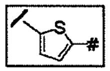 | 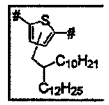 | 2 | 31,000 |
| Compound 55 | O | 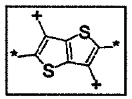 | 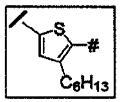 | 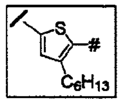 | 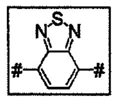 | 1 | 29,000 |

(continued)

| | W | Cy (In the following formulae, * represents a moiety linked to a N atom of a 3H-pyrrole ring, and + represents a moiety linked to a C atom of a C=W group.) | $Ar^1$ (In the following formulae, a wavy line represents a moiety linked to a 3H-pyrrole ring, and # represents a moiety linked to $V^1$.) | $Ar^2$ (In the following formulae, a wavy line represents a moiety linked to a 3H-pyrrole ring, and # represents a moiety linked to $V^1$.) | $V^1$ (In the following formulae, # represents a moiety linked to $Ar^1$.) | p | Weight average molecular weight |
|---|---|---|---|---|---|---|---|
| Compound 56 | O | 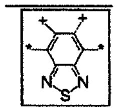 | 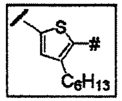 | 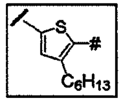 | 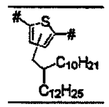 | 2 | 31,000 |
| Compound 57 | O | 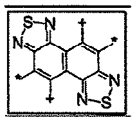 | 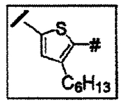 | 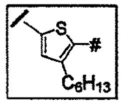 | 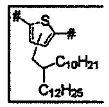 | 2 | 33,000 |

（５８）

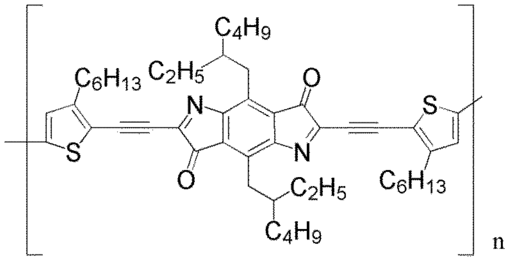

Mw=36,000

Specific examples of the compound having a repeating unit represented by Formula (1-3) will be shown below.

（６３）

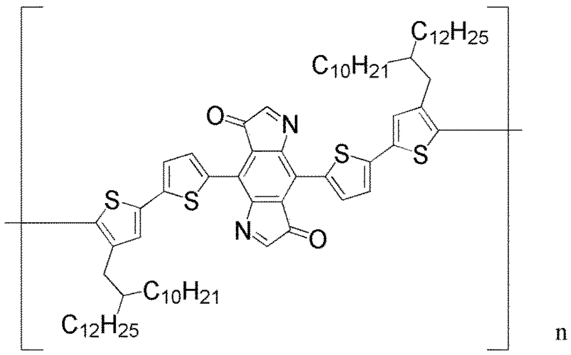

（６４）

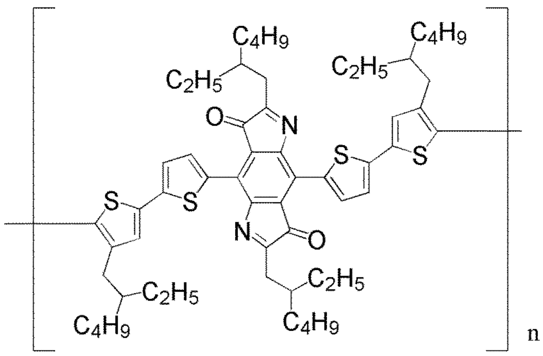

（６５）

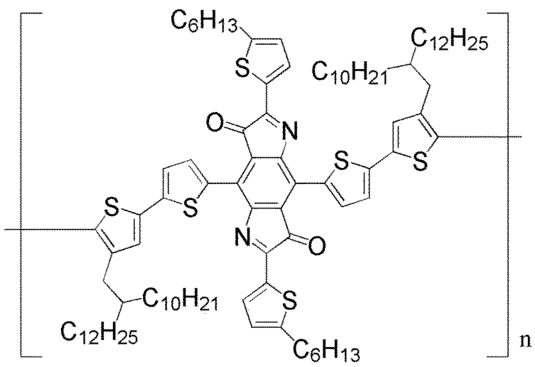

(66)

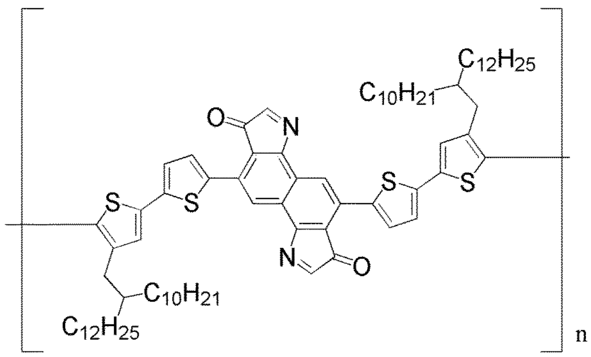

The compound having a repeating unit represented by Formula (1-2), or (1-3) described above is a compound having two or more repeating units, and may be an oligomer in which the number n of the repeating units is 2 to 9 or a polymer in which the number n of the repeating units is equal to or greater than 10.

In a case where the compound having a repeating unit represented by Formula (1-2), or (1-3) is an oligomer in which the number of repeating units is 2 to 9, the molecular weight thereof is preferably equal to or greater than 2,000, and more preferably equal to or greater than 5,000.

In a case where the compound having a repeating unit represented by Formula (1-2), or (1-3) is a polymer compound, the weight average molecular weight thereof is preferably equal to or greater than 30,000, more preferably equal to or greater than 50,000, and particularly preferably equal to or greater than 100,000. The upper limit of the molecular weight is not particularly limited, but it is preferably equal to or less than 1,000,000, and more preferably equal to or less than 750,000. It is preferable that the molecular weight is equal to or less than the upper limit described above, because then the intermolecular interaction can be improved, the improvement favors the transport of carriers, and the solubility in a solvent can be maintained.

In the present invention, the weight average molecular weight refers to a value obtained by dissolving a polymer in tetrahydrofuran (THF) and measuring the molecular weight thereof by gel permeation chromatography (GPC) by using high-performance GPC (HLC-8220GPC) manufactured by TOSOH CORPORATION. Furthermore, in the present invention, the weight average molecular weight is a value obtained by using polystyrene as a standard substance.

The compound having a repeating unit represented by Formula (1-2), or (1-3) can be synthesized with reference to the scheme 1, which will be described later, US7928249B, and the like.

In synthesizing the compound of the present invention, any of reaction conditions may be used. As a reaction solvent, any solvent may be used. Furthermore, in order to accelerating a ring forming reaction, an acid or a base is preferably used, and a base is particularly preferably used. The optimal reaction conditions vary with the intended structure, but can be set with reference to the specific reaction conditions described in the above documents.

<Intermediate compound>

The synthetic intermediate having various substituents can be synthesized using known reactions in combination. Furthermore, various substituents may be introduced into the intermediate at any stage. After the intermediate is synthesized, it is preferable to purify the intermediate by column chromatography, recrystallization, or the like.

The present invention also relates to a compound represented by the following Formula (6) and a compound represented by the following Formula (7).

Formula (6)

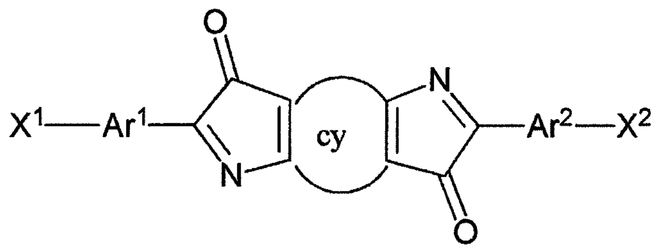

In Formula (6),

Cy represents an aromatic ring or a heterocyclic aromatic ring that may have a substituent,
each of $Ar^1$ and $Ar^2$ independently represents a heterocyclic aromatic ring or an aromatic ring, and
each of $X^1$ and $X^2$ independently represents a hydrogen atom, a halogen atom, a trifluoromethylsulfonyl group, a trialkylstannyl group, a boric acid ester group, or $-B(OH)_2$.

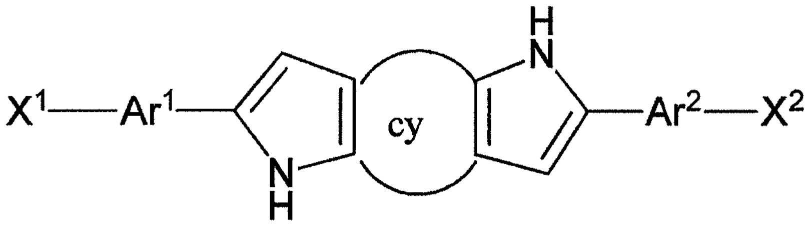

In Formula (7),

Cy represents an aromatic ring or a heterocyclic aromatic ring that may have a substituent,
each of $Ar^1$ and $Ar^2$ independently represents a heterocyclic aromatic ring or an aromatic ring, and
each of $X^1$ and $X^2$ independently represents a hydrogen atom, a halogen atom, a trifluoromethylsulfonyl group, a trialkylstannyl group, a boric acid ester group, or $-B(OH)_2$.

The compound represented by Formula (6) or (7) described above is preferably an intermediate compound of the compound having a repeating unit represented by the Formula (1-2) described above. The compound represented by the Formula (1-2) described above can be synthesized by preparing the compound represented by the Formula (6) described above from the compound represented by the Formula (7) described above according to the scheme 1, which will be described later, and then polycondensing only the compound represented by Formula (6) or copolymerizing the compound represented by Formula (6) with other copolymerization components.
Each of Cy, $Ar^1$, and $Ar^2$ in Formulae (6) and (7) has the same definition as each of Cy, $Ar^1$, and $Ar^2$ in Formula (1-2), and the preferred range thereof is also the same.
In Formulae (6) and (7), each of $X^1$ and $X^2$ independently represents a hydrogen atom, a halogen atom, a trifluoromethylsulfonyl group, a trialkylstannyl group, a boric acid ester group, or $-B(OH)_2$. Each of $X^1$ and $X^2$ is preferably a halogen atom, a trifluoromethylsulfonyl group, or a trialkylstannyl group, and more preferably independently represents a halogen atom or a trialkylstannyl group.
The halogen atom represented by each of $X^1$ and $X^2$ is preferably a chlorine atom, an iodine atom, or a bromine atom, and more preferably a bromine atom.
The trialkylstannyl group represented by each of $X^1$ and $X^2$ is preferably a trimethylstannyl group, and more preferably a tributylstannyl group.
Examples of the boric acid ester group represented by each of $X^1$ and $X^2$ include the boric acid ester groups described in WO2013/065836A. Among these, an ethylene glycol diester, a 1,3-propanediol ester, and a pinacol ester are more preferable.

<Structure of organic transistor>

The organic transistor of the present invention has a semiconductor active layer containing the compound having n repeating units represented by Formula (1-2), or (1-3).
The organic transistor of the present invention may further have layers other than the semiconductor active layer.
The organic transistor of the present invention is preferably used as an organic field effect transistor (FET), and is more preferably used as an insulated gate-type FET in which the gate is insulated from channels.
Hereinafter, preferred structural aspects of the organic transistor of the present invention will be specifically described by using drawings, but the present invention is not limited to the aspects.

(Lamination structure)

The lamination structure of an organic field effect transistor is not particularly limited, and various known structures can be adopted.
For example, the organic transistor of the present invention can adopt a structure (bottom gate/top contact type) in which an electrode, an insulator layer, a semiconductor active layer (organic semiconductor layer), and two electrodes are arranged in this order on the upper surface of a substrate which is a lower most layer. In this structure,

the electrode on the upper surface of the substrate as the lower most layer is provided in a portion of the substrate, and the insulator layer is so disposed that it comes into contact with the substrate in a portion other than the electrode. The two electrodes provided on the upper surface of the semiconductor active layer are arranged in a state of being separated from each other.

Fig. 1 shows the constitution of a bottom gate/top contact-type element. Fig. 1 is a schematic view showing a section of an exemplary structure of the organic transistor of the present invention. In the organic transistor shown in Fig. 1, a substrate 11 is disposed as a lower most layer, an electrode 12 is provided in a portion of the upper surface thereof, and an insulator layer 13 is provided such that it covers the electrode 12 and comes into contact with the substrate 11 in a portion other than the electrode 12. On the upper surface of the insulator layer 13, a semiconductor active layer 14 is provided, and in a portion of the upper surface thereof, two electrodes 15a and 15b separated from each other are arranged.

In the organic transistor shown in Fig. 1, the electrode 12 is a gate, and the electrode 15a and the electrode 15b are a drain and a source respectively. The organic transistor shown in Fig. 1 is an insulated gate-type FET in which a channel as a path of electric currents between the drain and the source is insulated from the gate.

As an example of the structure of the organic transistor of the present invention, a bottom gate/bottom contact-type element can be exemplified.

Fig. 2 shows the constitution of the bottom gate/bottom contact-type element. Fig. 2 is a schematic view showing a section of the structure of an organic transistor manufactured as a substrate for measuring FET characteristics in examples of the present invention. In the organic transistor shown in Fig. 2, a substrate 31 is disposed as a lower most layer, an electrode 32 is provided in a portion of the upper surface thereof, and an insulator layer 33 is provided such that it covers the electrode 32 and comes into contact with the substrate 31 in a portion other than the electrode 32. Furthermore, a semiconductor active layer 35 is provided on the upper surface of the insulator layer 33, and electrodes 34a and 34b are in a lower portion of the semiconductor active layer 35.

In the organic transistor shown in Fig. 2, the electrode 32 is a gate, and the electrode 34a and the electrode 34b are a drain and a source respectively. The organic transistor shown in Fig. 2 is an insulated gate-type FET in which a channel as a path of electric currents between the drain and the source is insulated from the gate.

As the structure of the organic transistor of the present invention, a top gate/top contact-type element in which an insulator and a gate electrode are in the upper portion of a semiconductor active layer or a top gate/bottom contact-type element can also be preferably used.

(Thickness)

In a case where the organic transistor of the present invention needs to be a thinner transistor, the total thickness of the transistor is preferably, for example, 0.1 μm to 0.5 μm.

(Sealing)

In order to improve the preservation stability of the organic transistor element by blocking the organic transistor element from the atmosphere or moisture, the entirety of the organic transistor element may be sealed with a metal sealing can, glass, an inorganic material such as silicon nitride, a polymer material such as parylene, a low-molecular weight material, or the like.

Hereinafter, preferred aspects of the respective layers of the organic transistor of the present invention will be described, but the present invention is not limited to the aspects.

<Substrate>

(Material)

The organic transistor of the present invention preferably includes a substrate.

The material of the substrate is not particularly limited, and known materials can be used. Examples of the material include a polyester film such as polyethylene naphthalate (PEN) or polyethylene terephthalate (PET), a cycloolefin polymer film, a polycarbonate film, a triacetylcellulose (TAC) film, a polyimide film, a material obtained by bonding these polymer films to extremely thin glass, ceramics, silicon, quartz, glass, and the like. Among these, silicon is preferable.

<Electrode>

(Material)

The organic transistor of the present invention preferably includes an electrode.

As the material constituting the electrode, known conductive materials such as a metal material like Cr, Al, Ta, Mo, Nb, Cu, Ag, Au, Pt, Pd, In, Ni, or Nd, an alloy material of these, a carbon material, and a conductive polymer can be used without particular limitation.

(Thickness)

The thickness of the electrode is not particularly limited, but is preferably 10 nm to 50 nm.

A gate width (or a channel width) W and a gate length (or a channel length) L are not particularly limited. However, a ratio of W/L is preferably equal to or greater than 10, and more preferably equal to or greater than 20.

<Insulating layer>

(Material)

The material constituting the insulating layer is not particularly limited as long as an insulating effect is obtained as required. Examples of the material include silicon dioxide, silicon nitride, a fluorine polymer-based insulating material such as PTFE or CYTOP, a polyester insulating material, a polycarbonate insulating material, an acryl polymer-based insulating material, an epoxy resin-based insulating material, a polyimide insulating material, a polyvinyl phenol resin-based insulating material, a poly p-xylylene resin-based insulating material, and the like.

A surface treatment may be performed on the upper surface of the insulating layer. For example, it is possible to preferably use an insulating layer in which the silicon dioxide surface thereof is subjected to the surface treatment by being coated with hexamethyldisilazane (HMDS) or octadecyltrichlorosilane (OTS).

(Thickness)

The thickness of the insulating layer is not particularly limited. However, in a case where the film needs to be thinned, the thickness of the insulating layer is preferably 10 nm to 400 nm, more preferably 20 nm to 200 nm, and particularly preferably 50 nm to 200 nm.

<Semiconductor active layer>

(Material)

In the organic transistor of the present invention, the semiconductor active layer contains the compound having n repeating units represented by Formula (1-2), or (1-3), that is, the compound of the present invention.

The semiconductor active layer may be a layer consisting of the compound of the present invention or a layer further containing a polymer binder, which will be described later, in addition to the compound of the present invention. Furthermore, the semiconductor active layer may contain a residual solvent used at the time of forming a film.

The content of the polymer binder in the semiconductor active layer is not particularly limited. However, the content of the polymer binder is preferably within a range of 0% by mass to 95% by mass, more preferably within a range of 10% by mass to 90% by mass, even more preferably within a range of 20% by mass to 80% by mass, and particularly preferably within a range of 30% by mass to 70% by mass.

(Thickness)

The thickness of the semiconductor active layer is not particularly limited. However, in a case where the film needs to be thinned, the thickness of the semiconductor active layer is preferably 10 nm to 400 nm, more preferably 10 nm to 200 nm, and particularly preferably 10 nm to 100 nm.

[Organic semiconductor material for non-light-emitting organic semiconductor device]

The present invention also relates to an organic semiconductor material for a non-light-emitting organic semiconductor device containing the compound having n repeating units represented by Formula (1-2), or (1-3), that is, the

compound of the present invention.

(Non-light-emitting organic semiconductor device)

In the present specification, a "non-light-emitting organic semiconductor device" refers to a device which is not used for the purpose of emitting light. The non-light-emitting organic semiconductor device preferably uses an electronic element having a layered structure consisting of films. The non-light-emitting organic semiconductor device includes an organic transistor, an organic photoelectric conversion element (a solid-state imaging element used for a photosensor, a solar cell used for energy conversion, or the like), a gas sensor, an organic rectifying element, an organic inverter, an information recording element, and the like. The organic photoelectric conversion element can be used for both a photosensor (solid-state imaging element) and for energy conversion (a solar cell). Among these, an organic photoelectric conversion element and an organic transistor are preferable, and an organic transistor is more preferable. That is, the organic semiconductor material for a non-light-emitting organic semiconductor device of the present invention is preferably a material for an organic transistor as described above.

(Organic semiconductor material)

In the present specification, the "organic semiconductor material" is an organic material showing characteristics of a semiconductor. Just as the semiconductor composed of an inorganic material, the organic semiconductor is classified into a p-type (hole-transporting) organic semiconductor material conducting holes as carriers and an n-type (electron-transporting) organic semiconductor material conducting electrons as carriers.

The compound of the present invention may be used as any of the p-type organic semiconductor material and the n-type organic semiconductor material, but is preferably used as the p-type. The ease with which the carriers flow in the organic semiconductor is represented by a carrier mobility $\mu$. The higher the carrier mobility $\mu$, the better. The carrier mobility $\mu$ is preferably equal to or greater than $1 \times 10^{-2}$ $cm^2/Vs$, more preferably equal to or greater than $5 \times 10^{-2}$ $cm^2/Vs$, particularly preferably equal to or greater than $1 \times 10^{-1}$ $cm^2/Vs$, and more particularly preferably equal to or greater than $2 \times 10^{-1}$ $cm^2/Vs$. The carrier mobility $\mu$ can be determined by the characteristics of the prepared field effect transistor (FET) element or by a time-of-flight (TOF) measurement method.

[Organic semiconductor film for non-light-emitting organic semiconductor device] (Material)

The present invention also relates to an organic semiconductor film for a non-light-emitting organic semiconductor device containing the compound having n repeating units represented by the Formula (1-2), or (1-3) described above, that is, the compound of the present invention.

As the organic semiconductor film for a non-light-emitting organic semiconductor device of the present invention, an aspect is also preferable in which the organic semiconductor film contains the compound having n repeating units represented by Formula (1-2) or (1-3), that is, the compound of the present invention, and does not contain a polymer binder.

Furthermore, the organic semiconductor film for a non-light-emitting organic semiconductor device of the present invention may contain the compound having n repeating units represented by Formula (1-2), or (1-3), that is, the compound of the present invention, and a polymer binder.

Examples of the polymer binder include an insulating polymer such as polystyrene, polycarbonate, polyarylate, polyester, polyamide, polyimide, polyurethane, polysiloxane, polysulfone, polymethyl methacrylate, polymethyl acrylate, cellulose, polyethylene, or polypropylene, a copolymer of these, a photoconductive polymer such as polyvinylcarbazole or polysilane, a conductive polymer such as polythiophene, polypyrrole, polyaniline, or poly p-phenylenevinylene, and a semiconductor polymer.

One kind of the aforementioned polymer binder may be used singly, or plural kinds thereof may be used concurrently.

The organic semiconductor material may be uniformly mixed with the polymer binder. Alternatively, the organic semiconductor material and the polymer binder may be totally or partially in a phase separation state. From the viewpoint of the charge mobility, a structure, in which the organic semiconductor and the binder are in a phase separation state along the film thickness direction in the film, is the most preferable because then the binder does not hinder the organic semiconductor from moving a charge.

Considering the mechanical strength of the film, a polymer binder having a high glass transition temperature is preferable. Furthermore, considering the charge mobility, a polymer binder having a structure not containing a polar group, a photoconductive polymer, and a conductive polymer are preferable.

The amount of the polymer binder used is not particularly limited. However, in the organic semiconductor film for a non-light-emitting organic semiconductor device of the present invention, the amount of the polymer binder used

is preferably within a range of 0% by mass to 95% by mass, more preferably within a range of 10% by mass to 90% by mass, even more preferably within a range of 20% by mass to 80% by mass, and particularly preferably within a range of 30% by mass to 70% by mass.

In the present invention, by adopting the aforementioned structure as the structure of the compound, an organic film having excellent film quality can be obtained. Specifically, because the compound obtained in the present invention has excellent crystallinity, a sufficient film thickness can be obtained, and the obtained organic semiconductor film for a non-light-emitting organic semiconductor device of the present invention has excellent quality.

(Film forming method)

The compound of the present invention may be formed into a film on a substrate by any method.

At the time of forming the film, the substrate may be heated or cooled. By varying the temperature of the substrate, it is possible to control the film quality or the packing of molecules in the film. The temperature of the substrate is not particularly limited. However, it is preferably between 0°C to 200°C, more preferably between 15°C to 100°C, and particularly preferably between 20°C to 95°C.

The compound of the present invention can be formed into a film on a substrate by a vacuum process or a solution process, and both of the processes are preferable.

Specific examples of the film forming method by a vacuum process include a physical vapor deposition method such as a vacuum vapor deposition method, a sputtering method, an ion plating method, or a molecular beam epitaxy (MBE) method and a chemical vapor deposition (CVD) method such as plasma polymerization, and it is particularly preferable to use a vacuum vapor deposition method.

The film forming method by a solution process refers to a method of dissolving an organic compound in a solvent which can dissolve the compound and forming a film by using the solution. Specifically, coating is performed using a composition of the present invention containing the compound having n repeating units represented by Formula (1-2), and (1-3) and an organic solvent. To be specific, it is possible to use general methods like a coating method such as a casting method, a dip coating method, a die coater method, a roll coater method, a bar coater method, or a spin coating method, various printing methods such as an ink jet method, a screen printing method, a gravure printing method, a flexographic printing method, an offset printing method, or a micro-contact printing method, and a Langmuir-Blodgett (LB) method. It is particularly preferable to use a casting method, a spin coating method, an ink jet method, a gravure printing method, a flexographic printing method, an offset printing method, or a micro-contact printing method.

The organic semiconductor film for a non-light-emitting organic semiconductor device of the present invention is preferably prepared by a solution coating method. In a case where the organic semiconductor film for a non-light-emitting organic semiconductor device of the present invention contains a polymer binder, it is preferable to prepare a coating solution by dissolving or dispersing a material, which will be formed into a layer, and a polymer binder in an appropriate solvent and to form the organic semiconductor film by various coating methods.

Hereinafter, a coating solution for a non-light-emitting organic semiconductor device of the present invention that can be used for forming a film by a solution process will be described.

[Composition and coating solution for non-light-emitting organic semiconductor device]

The present invention also relates to a composition and a coating solution for a non-light-emitting organic semiconductor device that contain the compound having n repeating units represented by Formula (1-2), or (1-3), that is, the compound of the present invention.

In a case where a film is formed on a substrate by using a solution process, a material which will be formed into a layer is dissolved or dispersed in either or both of an appropriate organic solvent (for example, a hydrocarbon-based solvent such as hexane, octane, decane, toluene, xylene, mesitylene, ethylbenzene, decalin, or 1-methylnaphthalene, a ketone-based solvent such as acetone, methyl ethyl ketone, methyl isobutyl ketone, or cyclohexanone, a halogenated hydrocarbon-based solvent such as dichloromethane, chloroform, tetrachloromethane, dichloroethane, trichloroethane, tetrachloroethane, chlorobenzene, dichlorobenzene, or chlorotoluene, an ester-based solvent such as ethyl acetate, butyl acetate, or amyl acetate, an alcohol-based solvent such as methanol, propanol, butanol, pentanol, hexanol, cyclohexanol, methyl cellosolve, ethyl cellosolve, or ethylene glycol, an ether-based solvent such as dibutylether, tetrahydrofuran, dioxane, or anisole, an amide·imide-based solvent such as N,N-dimethylformamide, N,N-dimethylacetamide, 1-methyl-2-pyrrolidone, or 1-methyl-2-imidazolidinone, a sulfoxide-based solvent such as dimethyl sulfoxide, or a nitrile-based solvent such as acetonitrile) and water so as to obtain a coating solution, and a film can be formed by various coating methods by using the coating solution. One kind of the solvent may be used singly, or plural kinds thereof may be used in combination. Among these, an aromatic hydrocarbon-based solvent, a halogenated hydrocarbon-based solvent, an ether-based solvent, or a ketone-based solvent is preferable, and an aromatic hydrocarbon-based solvent, an ether-based solvent, or a ketone-based solvent is more preferable. Specifically, toluene, xylene, mesitylene, tetralin,

chlorobenzene, dichlorobenzene, anisole, isophorone, diisopropylbenzene, and s-butylbenzene are more preferable, and toluene, xylene, tetralin, chlorobenzene, dichlorobenzene, diisopropylbenzene, and s-butylbenzene are particularly preferable. The concentration of the compound having n repeating units represented by Formula (1-2), or (1-3) in the coating solution is preferably 0.1% by mass to 80% by mass, more preferably 0.1% by mass to 10% by mass, and particularly preferably 0.5% by mass to 10% by mass. In this way, a film having an arbitrary thickness can be formed.

Among these, from the viewpoint of improving the solubility and carrier mobility of the compound having n repeating units represented by Formula (1-2), or (1-3), an organic solvent which is an aromatic solvent having a boiling point of equal to or higher than 150°C and does not contain active hydrogen is preferable. Examples of such a solvent include tetralin, dichlorobenzene, anisole, isophorone, diisopropylbenzene, s-butylbenzene, and the like. As the organic solvent used in the present invention, dichlorobenzene, tetralin, diisopropylbenzene, and s-butylbenzene are preferable, and tetralin, diisopropylbenzene, and s-butylbenzene are more preferable.

In order to form a film by a solution process, the material needs to dissolve in the solvent exemplified above, but simply dissolving in a solvent is not good enough. Generally, even the material formed into a film by a vacuum process can dissolve in a solvent to some extent. The solution process includes a step of coating a substrate with a material by dissolving the material in a solvent and then forming a film by evaporating the solvent, and many of the materials not suitable for being formed into a film by the solution process have high crystallinity. Therefore, the material is inappropriately crystallized (aggregated) in the aforementioned step, and hence it is difficult to form an excellent film. The compound having n repeating units represented by Formula (1-2), or (1-3) is also excellent in the respect that it is not easily crystallized (aggregated).

As the coating solution for a non-light-emitting organic semiconductor device of the present invention, an aspect is also preferable in which the coating solution contains the compound having n repeating units represented by Formula (1-2), or (1-3), that is, the compound of the present invention, and does not contain a polymer binder.

Furthermore, the coating solution for a non-light-emitting organic semiconductor device of the present invention may contain the compound having n repeating units represented by Formula (1-2), or (1-3), that is, the compound of the present invention, and a polymer binder. In this case, a material, which will be formed into a layer, and a polymer binder are dissolved or dispersed in an appropriate solvent described above so as to prepare a coating solution, and by using the coating solution, a film can be formed by various coating methods. The polymer binder can be selected from those described above.

Examples

Hereinafter, the characteristics of the present invention will be more specifically explained by describing examples and comparative examples. The materials, the amount thereof used, the proportion thereof, the content of treatment, the treatment procedure, and the like described in the following examples can be appropriately modified within a range that does not depart from the gist of the present invention. Accordingly, the scope of the present invention is not limited to the following specific examples.

[Example 1]

<Synthesis example> Synthesis of compounds 1, 4, 5, 8, 9, 12, 13, 15, 32, 33, 51, 57, and 58

According to a specific synthesis procedure shown in the following scheme, through a compound I-1 represented by Formula (7) and a compound M-1 represented by Formula (6), a compound 5 as the compound having n repeating units represented by Formula (1-2) was synthesized.

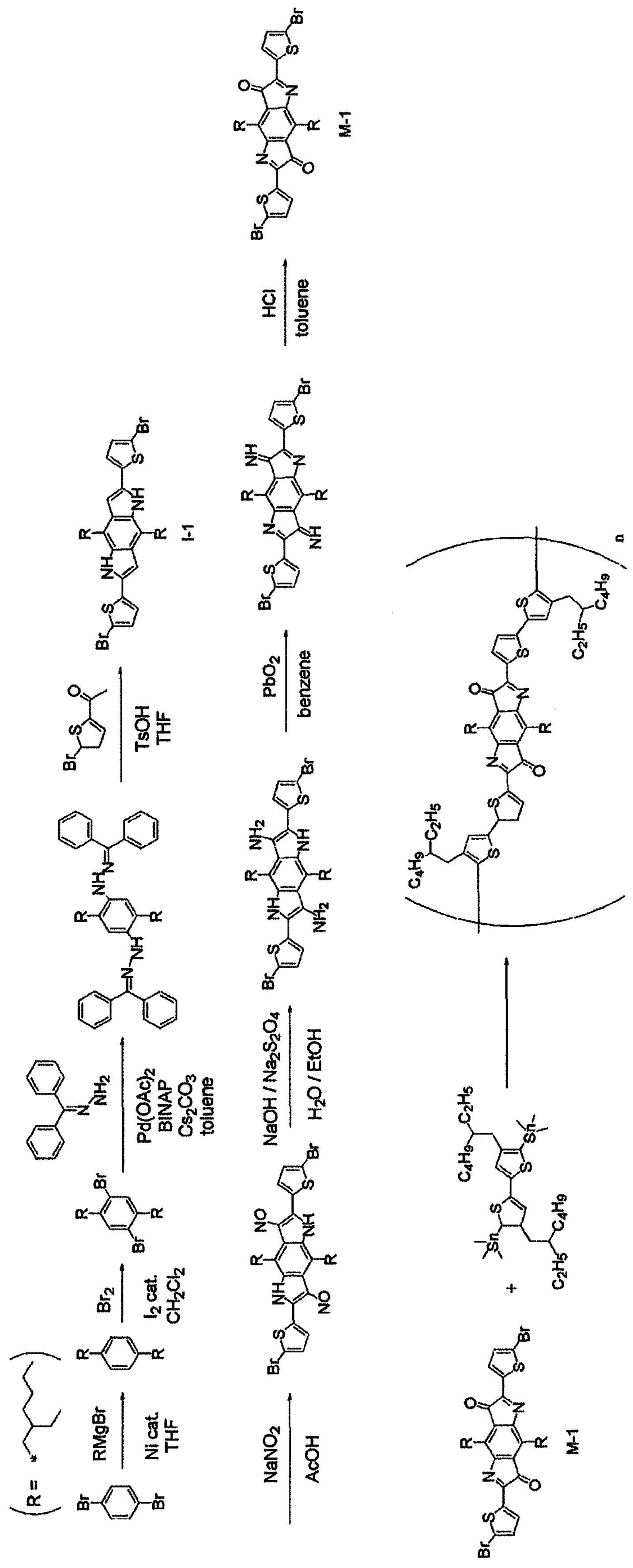

RMgBr
Ni cat.
THF
$Br_2$
$I_2$ cat.
$CH_2Cl_2$
$Pd(OAc)_2$
BINAP
$Cs_2CO_3$
toluene
TsOH
THF
I-1
$NaNO_2$
AcOH
NaOH / $Na_2S_2O_4$
$H_2O$ / EtOH
$PbO_2$
benzene
HCl
toluene
M-1


Compound 5

The obtained compound was identified by elementary analysis and NMR. Furthermore, the weight average molecular weight (Mw) of each compound was measured in the method described in the present specification.

The compound having n repeating units represented by Formula (1-2) that was used in other examples was synthesized in the same manner as used for the compound 5.

A compound 63 having n repeating units represented by Formula (1-3) that was used in examples was synthesized by a method analogous to the method for synthesizing the compound 5.

The structures of comparative compounds 1 to 4 are shown below.

The comparative compounds 1 to 3 were synthesized by the method described in JP2010-535270A. The comparative compound 1 corresponds to PDK described in JP2010-535270A, the comparative compound 2 corresponds to PDKT1 described in JP2010-535270A, and the comparative compound 3 corresponds to PDKT2 described in JP2010-535270A. Furthermore, the comparative compound 4 was synthesized by the method described in JP2012-177104A.

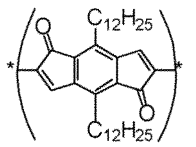

Comparative compound 1

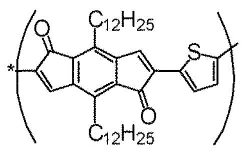

Comparative compound 2

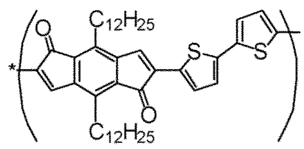

Comparative compound 3

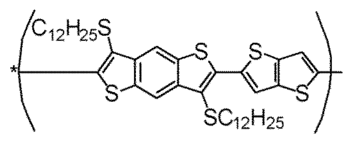

Comparative compound 4

<Preparation/evaluation of element>

[Example 2]

<Preparation of coating solution for non-light-emitting organic semiconductor device>

Each of the compounds of the present invention or the comparative compounds (10 mg each) was mixed with toluene (1 mL) and heated to 100°C, thereby preparing a coating solution for a non-light-emitting organic semiconductor device. The coating solution in which the compound was not completely dissolved was filtered using a 0.2 μm filter.

<Formation of semiconductor active layer (organic semiconductor layer) by using compound alone>

In the atmosphere, the coating solution for a non-light-emitting organic semiconductor device was subjected to spin coating, thereby forming an organic semiconductor film for a non-light-emitting organic semiconductor device. In this way, an organic transistor element of Example 3 for measuring FET characteristics was obtained. As the substrate for measuring FET characteristics, a silicon substrate comprising a bottom gate/bottom contact structure was used which included chromium/gold (gate width W = 100 mm, gate length L = 100 μm) arranged to form a comb pattern as source and drain electrodes and included $SiO_2$ (film thickness: 200 nm) as an insulating layer (the structure is schematically shown in Fig. 2).

By using a semiconductor parameter analyzer (4156C manufactured by Agilent Technologies) connected to a semi-automatic prober (AX-2000 manufactured by Vector Semiconductor Co., Ltd.), the FET characteristics of the organic transistor element of Example 2 were evaluated under a normal pressure/nitrogen atmosphere, from the viewpoint of the carrier mobility, the threshold voltage shift after repeated driving, and the film formability.

In addition, the coating solution for a non-light-emitting organic semiconductor device of Example 2 was evaluated from the viewpoint of the solubility.

The obtained results are shown in the following table.

(a) Evaluation of solubility

Each of the compounds of the present invention or the comparative compounds (10 mg each) was mixed with toluene (1 mL) and heated to 100°C. Then, the mixture was left to stand for 30 minutes at room temperature, and from the amount of solid precipitated, the solubility was evaluated into 3 levels as below.

A: No solid was precipitated.
B: The amount of solid precipitated was less than 30%.

C: The amount of solid precipitated was equal to or greater than 30%.

(b) Carrier mobility

Between the source electrode and the drain electrode of each organic transistor element (FET element), a voltage of -50 V was applied, and the gate voltage was varied within a range of 20 V to -100 V. In this way, a carrier mobility $\mu$ was calculated using an equation of $I_d = (w/2L)\mu C_i(V_g - V_{th})^2$ (wherein $I_d$ represents a drain current, L represents a gate length, W represents a gate width, $C_i$ represents a capacity of the insulating layer per unit area, $V_g$ represents a gate voltage, and $V_{th}$ represents a threshold voltage).

(b) Threshold voltage shift after repeated driving

Between the source electrode and the drain electrode of each organic transistor element (FET element), a voltage of -80 V was applied, and the element was repeatedly driven 100 times by varying the gate voltage within a range of +20 V to -100 V. In this way, the element was measured in the same manner as in the section (a), and a difference between a threshold voltage $V_{before}$ before the repeated driving and a threshold voltage $V_{after}$ after the repeated driving ($|V_{after} - V_{before}|$) was evaluated into 3 levels as below. The smaller the difference, the higher the stability of the element against repeated driving. Therefore, the smaller the difference, the more preferable.

$$A:\ |V_{after} - V_{before}| \leq 5\ V$$

$$B:\ 5\ V < |V_{after} - V_{before}| \leq 10\ V$$

$$C:\ |V_{after} - V_{before}| > 10\ V$$

(d) Evaluation of film formability

Each of the obtained organic transistor elements was observed with unaided eyes and an optical microscope. By the method described above, 10 elements were prepared, and the rate of cissing of the film on the source and drain electrodes was evaluated.

The results were evaluated into 3 levels as below.

A: Less than 10%

B: Equal to or greater than 10% and less than 30%

C: Equal to or greater than 30%

(e) Element variation

The mobility of the prepared 30 elements was measured, and a coefficient of variation was calculated. The results were evaluated into 3 levels as below.

A: Less than 30%

B: Equal to or greater than 30% and less than 50%

C: Equal to or greater than 50%

[Table 8]

| Element No. | Organic semiconductor material | Solubility | Carrier mobility | Threshold voltage shift after repeated driving | Film formability | Element variation |
|---|---|---|---|---|---|---|
| Element 1 | Compound 1 | A | 0.13 | A | A | A |
| Element 2 | Compound 4 | A | 0.21 | A | A | A |
| Element 3 | Compound 5 | A | 0.31 | A | A | A |
| Element 4 | Compound 32 | A | 0.35 | A | A | A |
| Element 5 | Compound 33 | A | 0.31 | A | A | A |
| Element 6 | Compound 8 | A | 0.30 | A | A | A |
| Element 7 | Compound 9 | A | 0.03 | A | A | A |
| Element 8 | Compound 58 | A | 0.05 | A | A | A |
| Element 9 | Compound 51 | A | 0.09 | A | A | A |
| Element 10 | Compound 12 | A | 0.11 | A | A | A |
| Element 11 | Compound 13 | A | 0.15 | A | A | A |
| Element 12 | Compound 15 | A | 0.18 | A | A | A |
| Element 14 | Compound 63 | A | 0.08 | A | A | A |
| Element 15 | Compound 57 | A | 0.11 | A | A | A |
| Comparative element 1 | Comparative compound 1 | C | $< 1 \times 10^{-5}$ | B | C | C |
| Comparative element 2 | Comparative compound 2 | C | $2 \times 10^{-4}$ | B | C | C |
| Comparative element 3 | Comparative compound 3 | C | $4 \times 10^{-3}$ | B | C | C |
| Comparative element 4 | Comparative compound 4 | C | 0.005 | C | C | C |

From the above table, it was understood that the organic transistor element of the present invention has high carrier mobility. Therefore, it was understood that the compound of the present invention can be preferably used as an organic semiconductor material for a non-light-emitting organic semiconductor device.

In contrast, the organic transistor elements using the comparative compounds 1 to 4 had low carrier mobility.

The compound represented by Formula (1-2), or (1-3) exhibited excellent solubility in an organic solvent, and the organic transistor element of the present invention using the compound represented by Formula (1-2), or (1-3) showed only a slight threshold voltage shift after repeated driving. Furthermore, it was understood that all of the organic transistor elements of the present invention using the compound represented by Formula (1-2), or (1-3) have extremely high smoothness/uniformity and excellent film formability. In addition, the organic transistor element of the present invention using the compound represented by Formula (1-2), or (1-3) had small variation and was excellent in driving stability.

[Example 3]

<Formation of semiconductor active layer (organic semiconductor layer)>

The surface of a silicon wafer, which comprised $SiO_2$ (film thickness: 370 nm) as a gate insulating film, was treated with octyltrichlorosilane.

Each of the compounds of the present invention or the comparative compounds (1 mg each) was mixed with toluene (1 mL), and the mixture was heated to 100°C, thereby preparing a coating solution for a non-light-emitting organic semiconductor device. In a nitrogen atmosphere, the coating solution was cast onto the silicon wafer which had been heated to 90°C and undergone surface treatment with octylsilane, thereby forming an organic semiconductor film for a

non-light-emitting organic semiconductor device.

Furthermore, gold was deposited onto the surface of the film by using a mask so as to prepare source and drain electrodes, thereby obtaining an organic transistor element having a bottom gate/top contact structure with a gate width W = 5 mm and a gate length L = 80 $\mu$m (the structure is schematically shown in Fig. 1).

By using a semiconductor parameter analyzer (4156C manufactured by Agilent Technologies) connected to a semi-automatic prober (AX-2000 manufactured by Vector Semiconductor Co., Ltd.), the FET characteristics of the organic transistor element of Example 4 were evaluated under a normal pressure/nitrogen atmosphere, from the viewpoint of the carrier mobility, the threshold voltage shift after repeated driving, and the film formability.

Furthermore, the coating solution for a non-light-emitting organic semiconductor device of Example 3 was evaluated from the viewpoint of the solubility.

As a result, it was understood that the same trend as in Example 2 is exhibited.

[Example 4]

<Formation of semiconductor active layer (organic semiconductor layer)>

The surface of a silicon wafer, which comprised $SiO_2$ (film thickness: 370 nm) as a gate insulating film, was treated with octyltrichlorosilane.

Each of the compounds of the present invention or the comparative compounds (1 mg each) was mixed with toluene (1 mL), and the mixture was heated to 100°C, thereby preparing a coating solution for a non-light-emitting organic semiconductor device. In a nitrogen atmosphere, the coating solution was cast onto the silicon wafer which had been heated to 90°C and undergone surface treatment with octylsilane, thereby forming an organic semiconductor film for a non-light-emitting organic semiconductor device.

Furthermore, gold was deposited onto the surface of the film by using a mask so as to prepare source and drain electrodes, thereby obtaining an organic transistor element having a bottom gate/top contact structure with a gate width W = 5 mm and a gate length L = 80 $\mu$m (the structure is schematically shown in Fig. 1).

By using a semiconductor parameter analyzer (4156C manufactured by Agilent Technologies) connected to a semi-automatic prober (AX-2000 manufactured by Vector Semiconductor Co., Ltd.), the FET characteristics of the organic transistor element of Example 4 were evaluated in the same manner as in Example 2 under a normal pressure/nitrogen atmosphere.

As a result, it was understood that the same trend as in Example 2 is exhibited.

Explanation of References

- 11: substrate
- 12: electrode
- 13: insulator layer
- 14: semiconductor active layer (organic substance layer, organic semiconductor layer)
- 15a, 15b: electrode
- 31: substrate
- 32: electrode
- 33: insulator layer
- 34a, 34b: electrode
- 35: semiconductor active layer (organic substance layer, organic semiconductor layer)

## Claims

1. An organic transistor comprising a compound having a repeating unit represented by the following Formula (1-2), or (1-3) in a semiconductor active layer, wherein said compound is an oligomer wherein the number of the repeating units is 2 to 9 or a polymer wherein the number of the repeating units is equal to or greater than 10;

Formula (1-2)

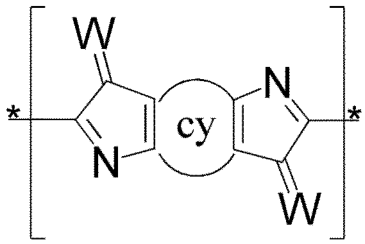

in Formula (1-2),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group, and
each $R^2$ independently represents a cyano group, an acyl group, a (per)fluoroalkyl group, or a (per)fluoroaryl group;

Formula (1-3)

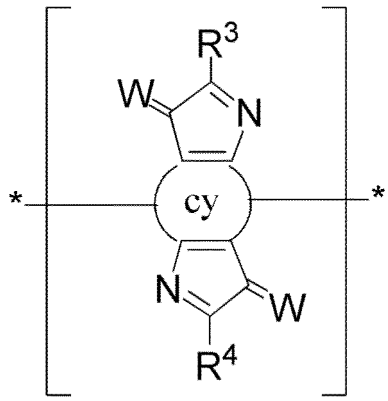

in Formula (1-3),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group,
each $R^2$ independently represents a cyano group, an acyl group, a (per)fluoroalkyl group, or a (per)fluoroaryl group, and
each of $R^3$ and $R^4$ independently represents a hydrogen atom or a monovalent substituent.

**2.** The organic transistor according to claim 1,
wherein the compound having a repeating unit represented by the Formula (1-2), or (1-3) is a compound having a repeating unit represented by the Formula (1-2).

**3.** The organic transistor according to claim 2,
wherein the compound having a repeating unit represented by the Formula (1-2) is a compound having a partial structure represented by the following Formula (1-2A);

Formula (1-2A)

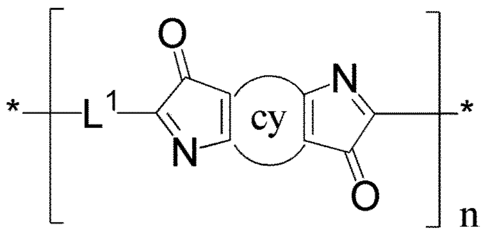

in Formula (1-2A),

Cy represents an aromatic ring or a heterocyclic aromatic ring that may have a substituent,
$L^1$ represents a single bond or a divalent linking group,
n represents an integer of equal to or greater than 2, and two or more Cy's and $L^1$'s may be the same as or different from each other.

**4.** The organic transistor according to claim 2, wherein the compound having a repeating unit represented by the Formula (1-2) is a compound having a partial structure represented by the following Formula (1-2B) and $V^1$ in the Formula (1-2B) is a single bond or a divalent linking group represented by any of the following Formulae (V-1) to (V-17);

Formula (1-2B)

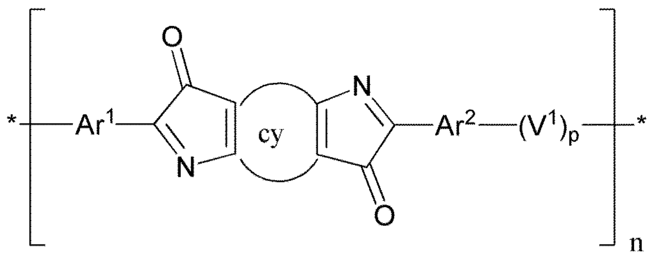

in Formula (1-2B),

Cy represents an aromatic ring or a heterocyclic aromatic ring that may have a substituent,
each of $Ar^1$ and $Ar^2$ independently represents a heteroarylene group or an arylene group,
$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more Cy's, $V^1$'s, $Ar^1$'s, and $Ar^2$'s may be the same as or different from each other;

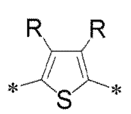
(V-1)

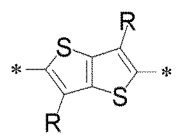
(V-2)

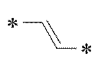
(V-3)

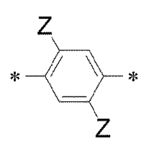
(V-4)

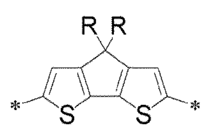
(V-5)

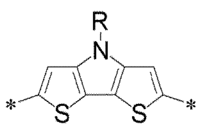
(V-6)

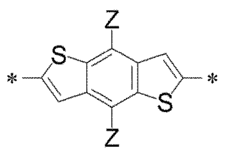
(V-7)

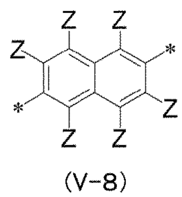
(V-8)

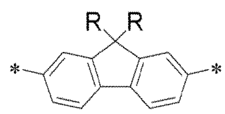
(V-9)

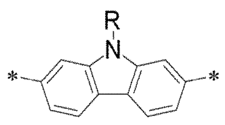
(V-10)

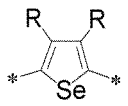
(V-11)

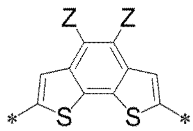
(V-12)

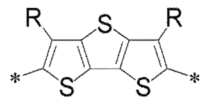
(V-13)

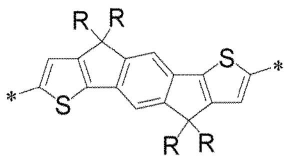
(V-14)

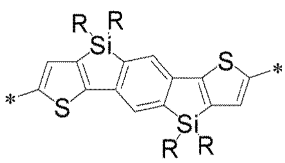
(V-15)

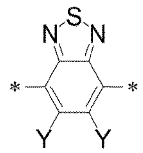
(V-16)

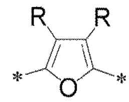
(V-17)

each R in Formulae (V-1), (V-2), (V-5), (V-6), (V-9) to (V-11), (V-13) to (V-15), and (V-17) independently represents a hydrogen atom or an alkyl group, R's adjacent to each other may form a ring by being bonded to each other,
each Z in Formulae (V-4), (V-7), (V-8), and (V-12) independently represents a hydrogen atom, an alkyl group, or an alkoxy group, Z's adjacent to each other may form a ring by being bonded to each other,
each Y in Formula (V-16) independently represents a hydrogen atom, an alkyl group, an alkoxy group, a CN group, or a F atom, and Y's adjacent to each other may form a ring by being bonded to each other.

**5.** A compound having a repeating unit represented by the following Formula (1-2) which is an oligomer wherein the number of the repeating units is 2 to 9 or a polymer wherein the number of the repeating units is equal to or greater than 10;

Formula (1-2)

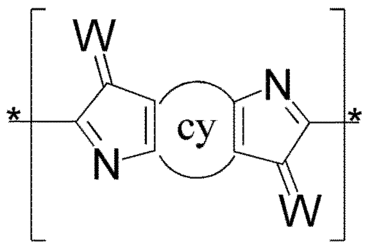

in Formula (1-2),

Cy represents an aromatic ring or a heterocyclic aromatic ring that may have a substituent,
each W independently represents an oxygen atom, a sulfur atom, $NR^1$, or $C(R^2)_2$,
$R^1$ represents a hydrogen atom, an alkyl group, an alkenyl group, an alkynyl group, an aryl group, or a heteroaryl group, and
each $R^2$ independently represents a cyano group, an acyl group, a (per)fluoroalkyl group, or a (per)fluoroaryl group.

**6.** The compound according to claim 5,
wherein the compound having a repeating unit represented by the Formula (1-2) is a compound having a partial structure represented by the following Formula (1-2A);

Formula (1-2A)

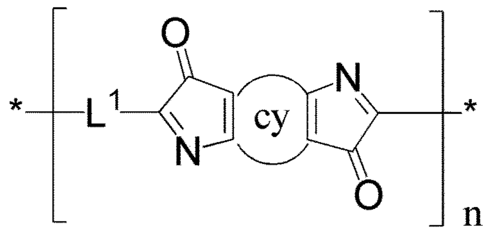

in Formula (1-2A),

Cy represents an aromatic ring or a heterocyclic aromatic ring that may have a substituent,
$L^1$ represents a single bond or a divalent linking group,
n represents an integer of equal to or greater than 2, and two or more Cy's and $L^1$'s may be the same as or different from each other.

**7.** The compound according to claim 5,
wherein the compound having a repeating unit represented by the Formula (1-2) is a compound having a partial structure represented by the following Formula (1-2B) and $V^1$ in the Formula (1-2B) is a divalent linking group represented by any of the following Formulae (V-1) to (V-17);

Formula (1-2B)

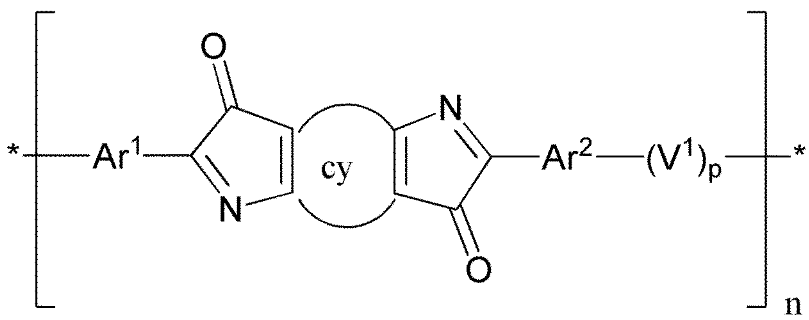

in Formula (1-2B),

Cy represents an aromatic ring or a heterocyclic aromatic ring that may have a substituent,
each of $Ar^1$ and $Ar^2$ independently represents a heteroarylene group or an arylene group,
$V^1$ represents a single bond or a divalent linking group,
p represents an integer of 1 to 6, when p is equal to or greater than 2, two or more $V^1$'s may be the same as or different from each other,
n represents an integer of equal to or greater than 2, and two or more Cy's, $V^1$'s, $Ar^1$'s, and $Ar^2$'s may be the same as or different from each other;

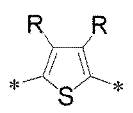
(V-1)

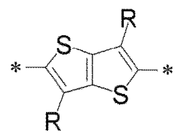
(V-2)

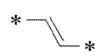
(V-3)

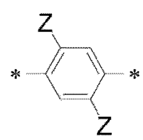
(V-4)

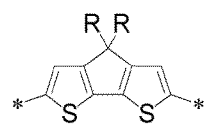
(V-5)

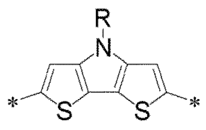
(V-6)

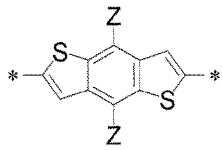
(V-7)

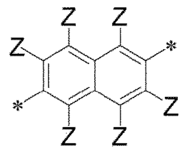
(V-8)

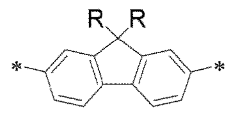
(V-9)

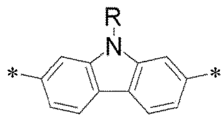
(V-10)

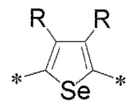
(V-11)

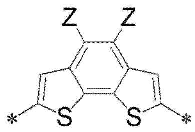
(V-12)

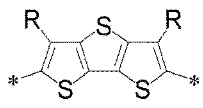
(V-13)

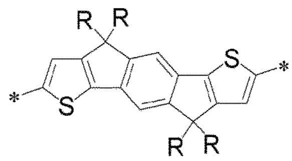
(V-14)

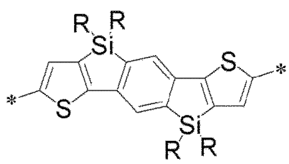
(V-15)

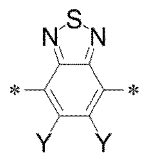
(V-16)

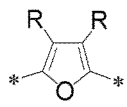
(V-17)

each R in Formulae (V-1), (V-2), (V-5), (V-6), (V-9) to (V-11), (V-13) to (V-15), and (V-17) independently represents a hydrogen atom or an alkyl group, R's adjacent to each other may form a ring by being bonded to each other,

each Z in Formulae (V-4), (V-7), (V-8), and (V-12) independently represents a hydrogen atom, an alkyl group, or an alkoxy group, Z's adjacent to each other may form a ring by being bonded to each other,

each Y in Formula (V-16) independently represents a hydrogen atom, an alkyl group, an alkoxy group, a CN group, or a F atom, and Y's adjacent to each other may form a ring by being bonded to each other.

**8.** The compound according to claim 7,
wherein in the Formula (1-2B), each of $Ar^1$ and $Ar^2$ is independently a divalent linking group represented by the following Formula (4-1), (4-2), or (4-3);

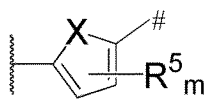
Formula (4-1)

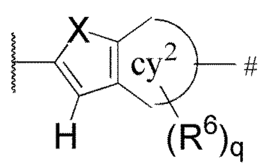
Formula (4-2)

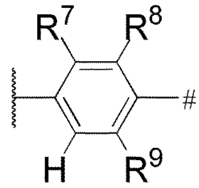
Formula (4-3)

in Formulae (4-1) to (4-3),

X represents a sulfur atom, an oxygen atom, or a Se atom,
$Cy^2$ represents a structure in which 1 to 4 rings are condensed,
each of $R^5$ to $R^9$ independently represents a hydrogen atom or a substituent,
m is 2,
q represents an integer of 0 to 6, when q is equal to or greater than 2, two or more $R^6$'s may be the same as or different from each other,
the wavy line represents a position of bonding to a moiety in which a 3H-pyrrol-3-one ring is condensed, and
# represents a position of bonding to $V^1$.

**9.** An organic semiconductor material for a non-light-emitting organic semiconductor device, comprising the compound having a repeating unit represented by the Formula (1-2), or (1-3) according to any one of claims 1 to 8.

**10.** A material for an organic transistor, comprising the compound having a repeating unit represented by the Formula (1-2), or (1-3) according to anyone of claims 1 to 8.

**11.** A coating solution for a non-light-emitting organic semiconductor device, comprising the compound having a repeating unit represented by the Formula (1-2), or (1-3) according to any one of claims 1 to 8.

**12.** An organic semiconductor film for a non-light-emitting organic semiconductor device, comprising the compound having a repeating unit represented by the Formula (1-2), or (1-3) according to any one of claims 1 to 8.

**13.** A compound represented by the following Formula (6);

Formula (6)

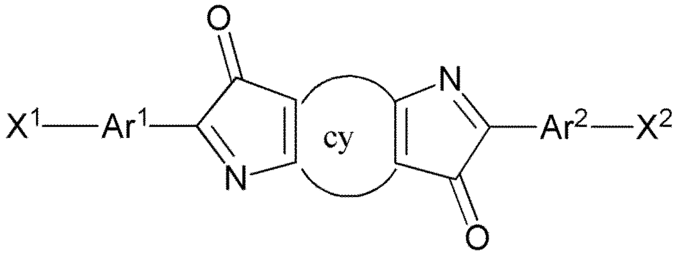

in Formula (6),

Cy represents an aromatic ring or a heterocyclic aromatic ring that may have a substituent,
each of $Ar^1$ and $Ar^2$ independently represents a heterocyclic aromatic ring or an aromatic ring, and
each of $X^1$ and $X^2$ independently represents a hydrogen atom, a halogen atom, a trifluoromethylsulfonyl group, a trialkylstannyl group, a boric acid ester group, or $-B(OH)_2$.

**14.** A compound represented by the following Formula (7);

Formula (7)

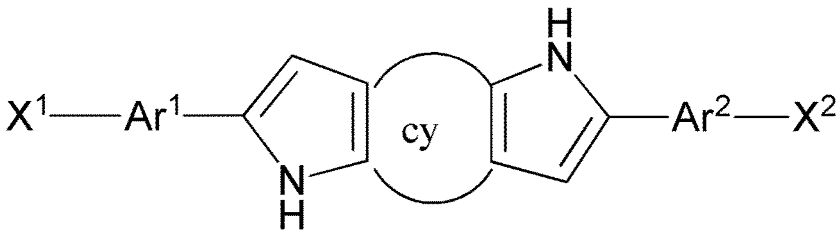

in Formula (7),

Cy represents an aromatic ring or a heterocyclic aromatic ring that may have an alkyl group having 1 to 50 carbon atoms as a substituent,
each of $Ar^1$ and $Ar^2$ independently represents a heterocyclic aromatic ring or an aromatic ring, and
each of $X^1$ and $X^2$ independently represents a halogen atom, a trifluoromethylsulfonyl group, a trialkylstannyl group, a boric acid ester group, or $-B(OH)_2$.

**Patentansprüche**

**1.** Organischer Transistor, enthaltend eine Verbindung mit einer Wiederholungseinheit mit der folgenden Formel (1-2) oder (1-3) in einer Halbleiter-Aktivschicht, worin die Verbindung ein Oligomer, worin die Zahl der Wiederholungseinheiten 2 bis 9 ist, oder ein Polymer ist, worin die Zahl der Wiederholungseinheiten gleich oder größer als 10 ist,

Formel (1-2)

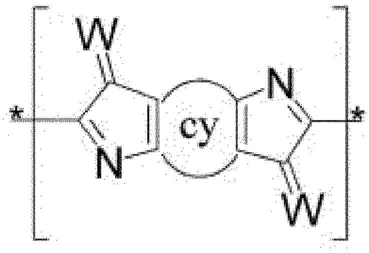

worin in der Formel (1-2) Cy ein aromatischer Ring oder ein heterocyclischer aromatischer Ring ist, der einen Substituenten haben kann,
jedes W unabhängig ein Sauerstoffatom, Schwefelatom, $NR^1$ oder $C(R^2)_2$ ist,
$R^1$ ein Wasserstoffatom, eine Alkylgruppe, Alkenylgruppe, Alkinylgruppe, Arylgruppe oder Heteroarylgruppe ist und
jedes $R^2$ unabhängig eine Cyanogruppe, Acylgruppe, (Per)fluoralkylgruppe oder (Per)fluorarylgruppe ist,

Formel (1-3)

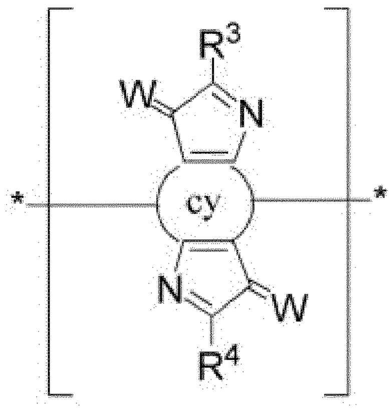

worin in der Formel (1-3) Cy ein aromatischer Ring oder ein heterocyclischer aromatischer Ring ist, der einen Substituenten haben kann,
jedes W unabhängig ein Sauerstoffatom, Schwefelatom, $NR^1$ oder $C(R^2)_2$ ist,
$R^1$ ein Wasserstoffatom, eine Alkylgruppe, Alkenylgruppe, Alkinylgruppe, Arylgruppe oder Heteroarylgruppe ist,
jedes $R^2$ unabhängig eine Cyanogruppe, Acylgruppe, (Per)fluoralkylgruppe oder (Per)fluorarylgruppe ist und
jedes $R^3$ und $R^4$ unabhängig ein Wasserstoffatom oder ein monovalenter Substituent ist.

**2.** Organischer Transistor gemäß Anspruch 1, worin die Verbindung mit einer Wiederholungseinheit mit der Formel (1-2) oder (1-3) eine Verbindung mit einer Wiederholungseinheit mit der Formel (1-2) ist.

**3.** Organischer Transistor gemäß Anspruch 2, worin die Verbindung mit einer Wiederholungseinheit mit der Formel (1-2) eine Verbindung mit einer Teilstruktur mit der folgenden Formel (1-2A) ist

Formel (1-2A)

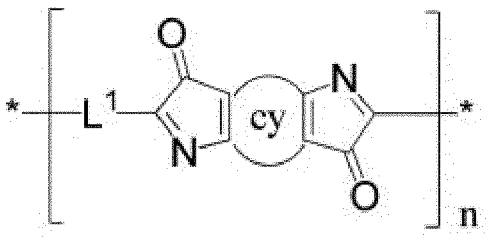

worin in der Formel (1-2A) Cy ein aromatischer Ring oder ein heterocyclischer aromatischer Ring ist, der einen Substituenten haben kann,
$L^1$ eine Einfachbindung oder eine bivalente Bindegruppe ist,
n eine ganze Zahl von gleich oder mehr als 2 ist und zwei oder mehrere Cy und $L^1$ gleich oder verschieden voneinander sein können.

**4.** Organischer Transistor gemäß Anspruch 2, worin die Verbindung mit einer Wiederholungseinheit mit der Formel (1-2) eine Verbindung mit einer Teilstruktur mit der folgenden Formel (1-2B) ist und $V^1$ in der Formel (1-2B) eine Einfachbindung oder eine bivalente Bindegruppe mit einer der folgenden Formeln (V-1) bis (V-17) ist:

Formel (1-2B)

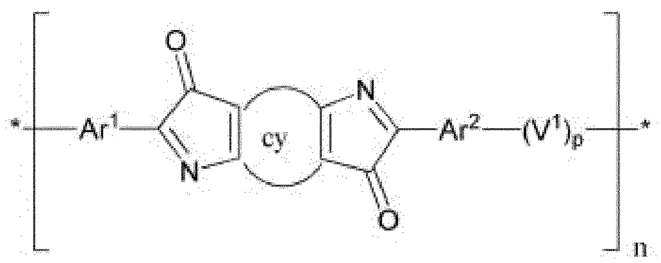

worin in der Formel (1-2B) Cy ein aromatischer Ring oder ein heterocyclischer aromatischer Ring ist, der einen Substituenten haben kann,
jedes von $Ar^1$ und $Ar^2$ unabhängig eine Heteroarylengruppe oder Arylengruppe sind,
$V^1$ eine Einfachbindung oder bivalente Bindegruppe ist,
p eine ganze Zahl von 1 bis 6 ist, worin dann, wenn p gleich oder größer als 2 ist, zwei oder mehrere $V^1$ gleich oder verschieden voneinander sein können,
n eine ganze Zahl von gleich oder mehr als 2 ist und zwei oder mehrere Gruppen Cy, $V^1$, $Ar^1$ und $Ar^2$ gleich oder verschieden voneinander sein können,

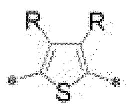
(V-1)

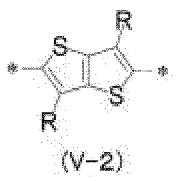
(V-2)

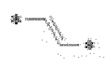
(V-3)

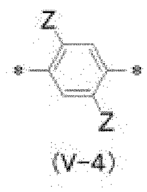
(V-4)

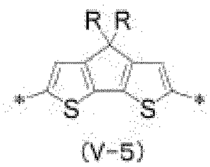
(V-5)

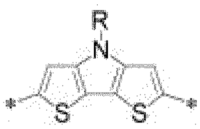
(V-6)

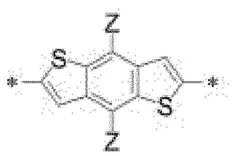
(V-7)

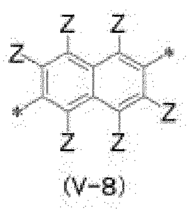
(V-8)

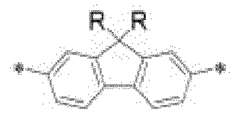
(V-9)

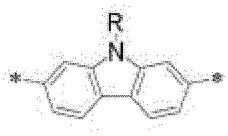
(V-10)

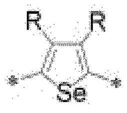
(V-11)

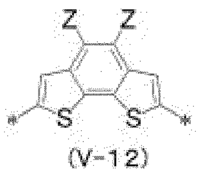
(V-12)

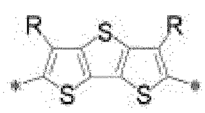
(V-13)

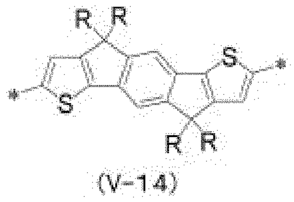

(V-14)

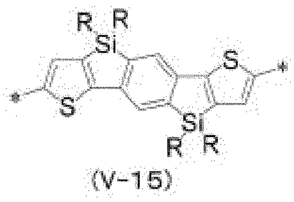

(V-15)

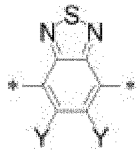

(V-16)

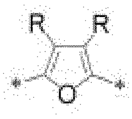

(V-17)

worin jedes R in den Formeln (V-1), (V-2), (V-5), (V-6), (V-9) bis (V-11), (V-13) bis (V-15) und (V-17) unabhängig ein Wasserstoffatom oder eine Alkylgruppe ist, die zueinander benachbarten Gruppen R einen Ring bilden können, indem sie aneinander gebunden sind,
jedes Z in den Formeln (V-4), (V-7), (V-8) und (V-12) unabhängig ein Wasserstoffatom, eine Alkylgruppe oder Alkoxygruppe ist, die zueinander benachbarten Gruppen Z einen Ring bilden können, indem sie aneinander gebunden sind,
jedes Y in der Formel (V-16) unabhängig ein Wasserstoffatom, eine Alkylgruppe, Alkoxygruppe, CN-Gruppe oder ein F-Atom ist und zueinander benachbarte Gruppen Y einen Ring bilden können, indem sie aneinander gebunden sind.

**5.** Verbindung mit einer Wiederholungseinheit mit der folgenden Formel (1-2), die ein Oligomer, worin die Zahl der Wiederholungseinheiten 2 bis 9 ist, oder ein Polymer ist, worin die Zahl der Wiederholungseinheiten gleich oder größer als 10 ist,

Formel (1-2)

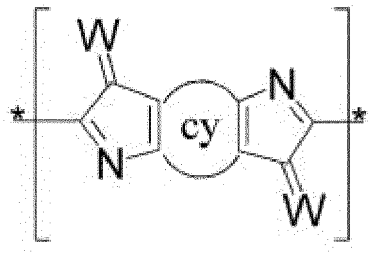

worin in der Formel (1-2) Cy ein aromatischer Ring oder ein heterocyclischer aromatischer Ring ist, der einen Substituenten haben kann,
jedes W unabhängig ein Sauerstoffatom, Schwefelatom, $NR^1$ oder $C(R^2)_2$ ist,
$R^1$ ein Wasserstoffatom, eine Alkylgruppe, Alkenylgruppe, Alkinylgruppe, Arylgruppe oder Heteroarylgruppe ist und
jedes $R^2$ unabhängig eine Cyanogruppe, Acylgruppe, (Per)fluoralkylgruppe oder (Per)fluorarylgruppe ist.

**6.** Verbindung gemäß Anspruch 5, worin die Verbindung mit einer Wiederholungseinheit mit der Formel (1-2) eine Verbindung mit einer Teilstruktur mit der folgenden Formel (1-2A) ist:

Formel (1-2A)

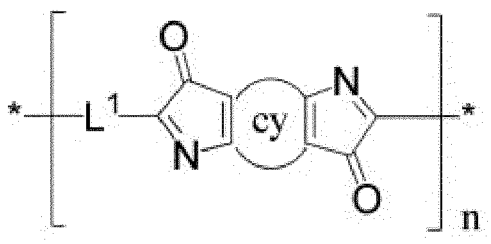

worin in der Formel (1-2A) Cy ein aromatischer Ring oder ein heterocyclischer aromatischer Ring ist, der einen Substituenten haben kann,

$L^1$ eine Einfachbindung oder eine bivalente Bindegruppe ist,
n eine ganze Zahl von gleich oder mehr als 2 ist und zwei oder mehrere Cy und $L^1$ gleich oder verschieden voneinander sein können.

**7.** Verbindung gemäß Anspruch 5, worin die Verbindung mit einer Wiederholungseinheit mit der Formel (1-2) eine Verbindung mit einer Teilstruktur mit der folgenden Fomel (1 -2B) ist und $V^1$ in der Formel (1 - 2B) eine Einfachbindung oder eine bivalente Bindegruppe mit einer der folgenden Formeln (V-1) bis (V-17) ist:

Formel (1-2B)

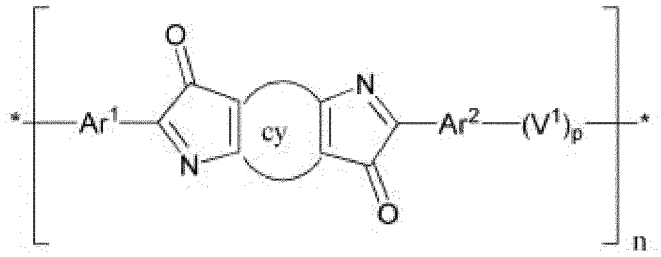

worin in der Formel (1-2B) Cy ein aromatischer Ring oder ein heterocyclischer aromatischer Ring ist, der einen Substituenten haben kann,
jedes von $Ar^1$ und $Ar^2$ unabhängig eine Heteroarylengruppe oder Arylengruppe sind,
$V^1$ eine Einfachbindung oder bivalente Bindegruppe ist,
p eine ganze Zahl von 1 bis 6 ist, worin dann, wenn p gleich oder größer als 2 ist, zwei oder mehrere $V^1$ gleich oder verschieden voneinander sein können,
n eine ganze Zahl von gleich oder mehr als 2 ist und zwei oder mehrere Gruppen Cy, $V^1$, $Ar^1$ und $Ar^2$ gleich oder verschieden voneinander sein können,

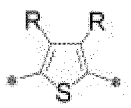
(V-1)

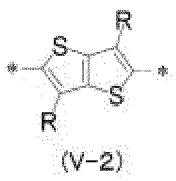
(V-2)

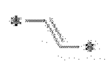
(V-3)

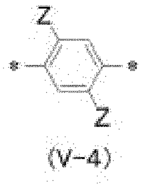
(V-4)

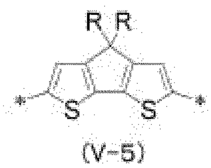
(V-5)

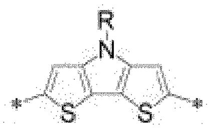
(V-6)

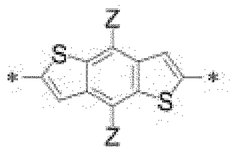
(V-7)

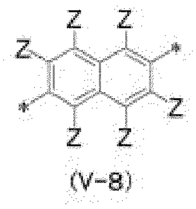
(V-8)

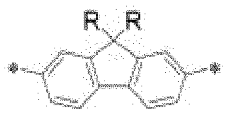
(V-9)

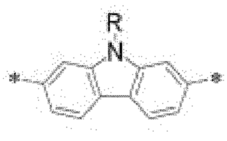
(V-10)

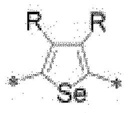
(V-11)

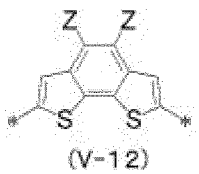
(V-12)

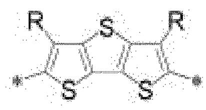
(V-13)

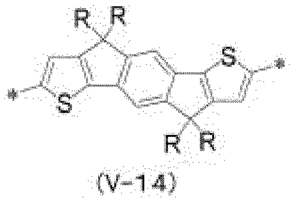

(V-14)

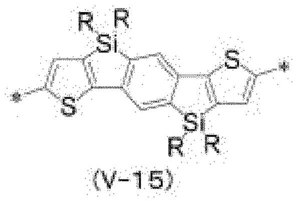

(V-15)

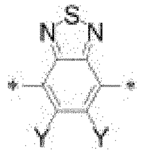

(V-16)

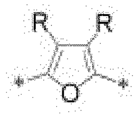

(V-17)

worin jedes R in den Formeln (V-1), (V-2), (V-5), (V-6), (V-9) bis (V-11), (V-13) bis (V-15) und (V-17) unabhängig ein Wasserstoffatom oder eine Alkylgruppe ist, die zueinander benachbarten Gruppen R einen Ring bilden können, indem sie aneinander gebunden sind,
jedes Z in den Formeln (V-4), (V-7), (V-8) und (V-12) unabhängig ein Wasserstoffatom, eine Alkylgruppe oder Alkoxygruppe ist, die zueinander benachbarten Gruppen Z einen Ring bilden können, indem sie aneinander gebunden sind,
jedes Y in der Formel (V-16) unabhängig ein Wasserstoffatom, eine Alkylgruppe, Alkoxygruppe, CN-Gruppe oder ein F-Atom ist und zueinander benachbarte Gruppen Y einen Ring bilden können, indem sie aneinander gebunden sind.

**8.** Verbindung gemäß Anspruch 7, worin in der Formel (1-2B) jedes von $Ar^1$ und $Ar^2$ unabhängig eine bivalente Bindegruppe ist, dargestellt durch die folgenden Formeln (4-1), (4-2) oder (4-3),

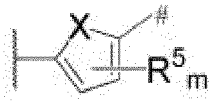

Formel (4-1)

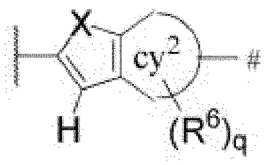

Formel (4-2)

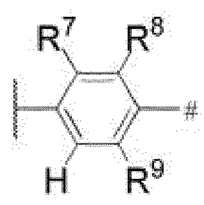

Formel (4-3)

worin in den Formeln (4-1) bis (4-3) X ein Schwefelatom, Sauerstoffatom oder Se-Atom ist,
$Cy^2$ eine Struktur ist, worin 1 bis 4 Ringe kondensiert sind,
jedes von $R^5$ bis $R^9$ unabhängig ein Wasserstoffatom oder ein Substituent sind,
m 2 ist,
q eine ganze Zahl von 0 bis 6 ist, worin dann, wenn q gleich oder größer als 2 ist, zwei oder mehrere Gruppen $R^6$ gleich oder verschieden voneinander sein können,
die Wellenlinie eine Position der Bindung an einen Anteil ist, worin ein 3H-Pyrrol-3-on-Ring kondensiert ist, und
\# eine Position der Bindung an $V^1$ ist.

**9.** Organisches Halbleitermaterial für eine nicht-lichtemittierende organische Halbleitervorrichtung, enthaltend die Verbindung mit einer Wiederholungseinheit mit der Formel (1-2) oder (1-3) gemäß einem der Ansprüche 1 bis 8.

**10.** Material für einen organischen Transistor, enthaltend die Verbindung mit einer Wiederholungseinheit mit der Formel (1-2) oder (1-3) gemäß einem der Ansprüche 1 bis 8.

**11.** Beschichtungslösung für eine nicht-lichtemittierende organische Halbleitervorrichtung, enthaltend die Verbindung mit einer Wiederholungseinheit mit der Formel (1-2) oder (1-3) gemäß einem der Ansprüche 1 bis 8.

**12.** Organischer Halbleiterfilm für eine nicht-lichtemittierende organische Halbleitervorrichtung, enthaltend die Verbindung mit einer Wiederholungseinheit mit der Formel (1-2) oder (1-3) gemäß einem der Ansprüche 1 bis 8.

**13.** Verbindung mit der folgenden Formel (6),

Formel (6)

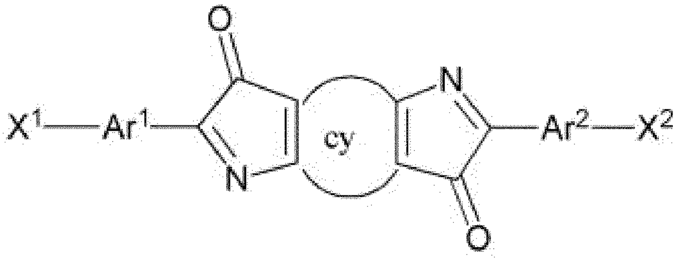

worin in der Formel (6) Cy ein aromatischer Ring oder heterocyclischer aromatischer Ring ist, der einen Substituenten haben kann,
jedes von $Ar^1$ und $Ar^2$ unabhängig ein heterocyclischer aromatischer Ring oder aromatischer Ring ist und jedes von $X^1$ und $X^2$ unabhängig ein Wasserstoffatom, Halogenatom, eine Trifluormethylsulfonylgruppe, Trialkylstannylgruppe, Borsäureestergruppe oder $-B(OH)_2$ ist.

**14.** Verbindung mit der folgenden Formel (7),

Formel (7)

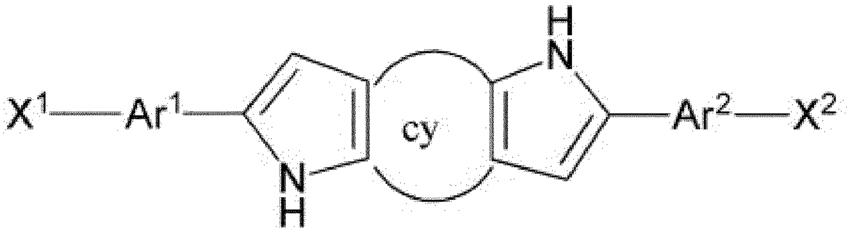

worin in der Formel (7) Cy ein aromatischer Ring oder heterocyclischer aromatischer Ring ist, der eine Alkylgruppe mit 1 bis 50 Kohlenstoffatomen als Substituenten haben kann,
jedes von $Ar^1$ und $Ar^2$ unabhängig ein heterocyclischer aromatischer Ring oder aromatischer Ring ist und jedes von $X^1$ und $X^2$ unabhängig ein Halogenatom, eine Trifluormethylsulfonylgruppe, Trialkylstannylgruppe, Borsäureestergruppe oder $-B(OH)_2$ ist.

## Revendications

**1.** Transistor organique comprenant un composé ayant un motif répétitif représenté par la formule (1-2) ou (1-3) suivante dans une couche active de semi-conducteur, dans lequel ledit composé est un oligomère dans lequel le nombre de motifs répétitifs est de 2 à 9 ou un polymère dans lequel le nombre de motifs répétitifs est égal ou supérieur à 10;

Formule (1-2)

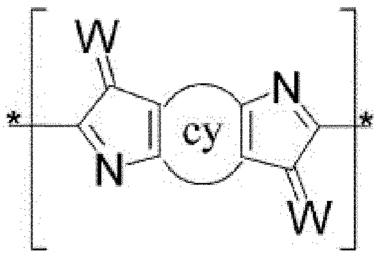

dans la formule (1-2),

Cy représente un cycle aromatique ou un cycle aromatique hétérocyclique qui peut avoir un substituant, chaque W représente indépendamment un atome d'oxygène, un atome de soufre, $NR^1$, ou $C(R^2)_2$, $R^1$ représente un atome d'hydrogène, un groupe alkyle, un groupe alcényle, un groupe alcynyle, un groupe aryle, ou un groupe hétéroaryle, et chaque $R^2$ représente indépendamment un groupe cyano, un groupe acyle, un groupe (per)fluoroalkyle, ou un groupe (per)fluoroaryle ;

Formule (1-3)

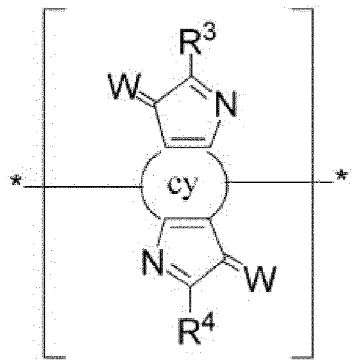

dans la formule (1-3),

Cy représente un cycle aromatique ou un cycle aromatique hétérocyclique qui peut avoir un substituant, chaque W représente indépendamment un atome d'oxygène, un atome de soufre, $NR^1$, ou $C(R^2)_2$, $R^1$ représente un atome d'hydrogène, un groupe alkyle, un groupe alcényle, un groupe alcynyle, un groupe aryle, ou un groupe hétéroaryle, chaque $R^2$ représente indépendamment un groupe cyano, un groupe acyle, un groupe (per)fluoroalkyle, ou un groupe (per)fluoroaryle, et chacun parmi $R^3$ et $R^4$ représente indépendamment un atome d'hydrogène ou un substituant monovalent.

**2.** Transistor organique selon la revendication 1, dans lequel le composé ayant un motif répétitif représenté par la formule (1-2), ou (1-3) est un composé ayant un motif répétitif représenté par la formule (1-2).

**3.** Transistor organique selon la revendication 2, dans lequel le composé ayant un motif répétitif représenté par la formule (1-2) est un composé ayant une structure partielle représentée par la formule (1-2A) suivante ;

Formule (1-2A)

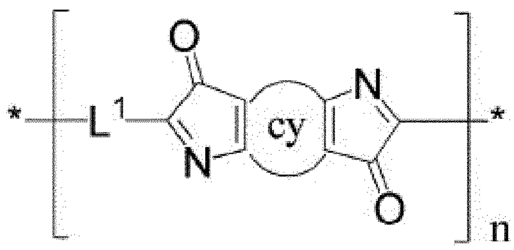

dans la formule (1-2A),

Cy représente un cycle aromatique ou un cycle aromatique hétérocyclique qui peut avoir un substituant, $L^1$ représente une liaison simple ou un groupe de liaison divalent ; n représente un nombre entier égal ou supérieur à 2, et deux ou plus de deux Cy et $L^1$ peuvent être identiques les uns aux autres ou différents les uns des autres.

**4.** Transistor organique selon la revendication 2, dans lequel le composé ayant un motif répétitif représenté par la formule (1-2) est un composé ayant une structure partielle représentée par la formule (1-2B) suivante et $V^1$ dans la formule (1-2B) est une liaison simple ou un groupe de liaison divalent représenté par l'une quelconque des formules (V-1) et (V-17) suivantes ;

Formule (1-2B)

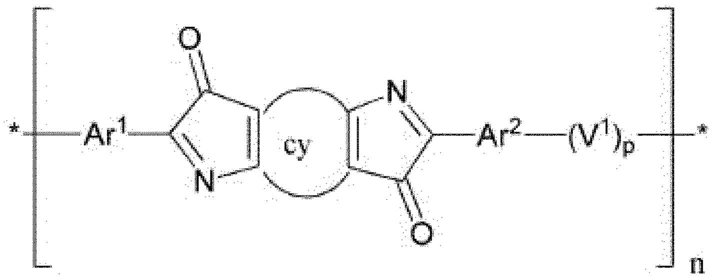

dans la formule (1-2B),

Cy représente un cycle aromatique ou un cycle aromatique hétérocyclique qui peut avoir un substituant, chacun parmi $Ar^1$ et $Ar^2$ représente indépendamment un groupe hétéroarylène ou un groupe arylène, $V^1$ représente une liaison simple ou un groupe de liaison divalent, p représente un nombre entier allant de 1 à 6, quand p est égal ou supérieur à 2, deux ou plus de deux $V^1$ peuvent être identiques les uns aux autres ou différents les uns des autres, n représente un nombre entier égal ou supérieur à 2, et deux ou plus de deux Cy, $V^1$, $Ar^1$, et $Ar^2$ peuvent être identiques les uns aux autres ou différents les uns des autres ;

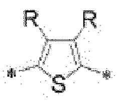
(V-1)

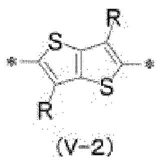
(V-2)

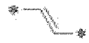
(V-3)

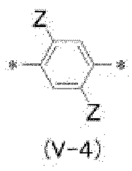
(V-4)

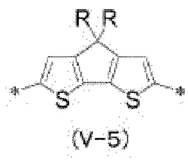
(V-5)

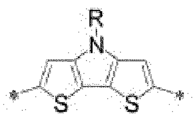
(V-6)

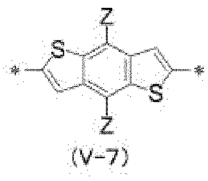
(V-7)

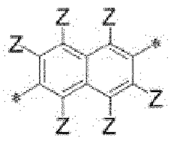
(V-8)

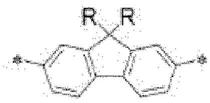
(V-9)

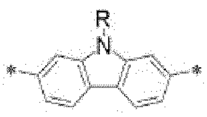
(V-10)

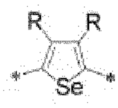
(V-11)

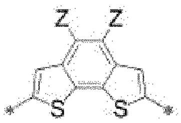
(V-12)

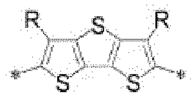
(V-13)

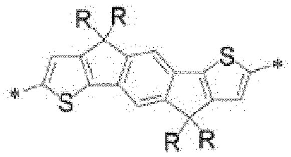
(V-14)

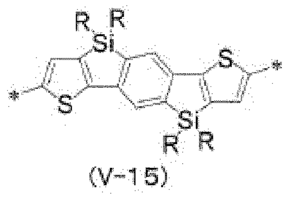
(V-15)

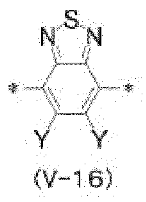
(V-16)

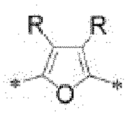
(V-17)

chaque R dans les formules (V-1), (V-2), (V-5), (V-6), (V-9) à (V-11), (V-13) à (V-15), et (V-17) représente indépendamment un atome d'hydrogène ou un groupe alkyle, des R adjacents les uns aux autres peuvent

former un cycle en étant liés les uns aux autres,
chaque Z dans les formules (V-4), (V-7), (V-8), et (V-12) représente indépendamment un atome d'hydrogène, un groupe alkyle, ou un groupe alcoxy, des Z adjacents les uns aux autres peuvent former un cycle en étant liés les uns aux autres,
chaque Y dans la formule (V-16) représente indépendamment un atome d'hydrogène, un groupe alkyle, un groupe alcoxy, un groupe CN, ou un atome F, et des Y adjacents les uns aux autres peuvent former un cycle en étant liés les uns aux autres.

**5.** Composé ayant un motif répétitif représenté par la formule (1-2) suivante qui est un oligomère dans lequel le nombre de motifs répétitifs est de 2 à 9 ou un polymère dans lequel le nombre des motifs répétitifs est supérieur ou égal à 10 ;

Formule (1-2)

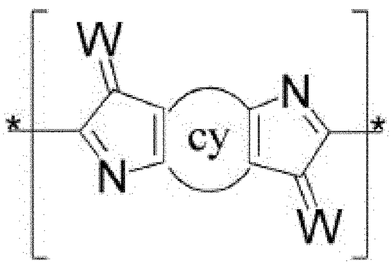

dans la formule (1-2),

Cy représente un cycle aromatique ou un cycle aromatique hétérocyclique qui peut avoir un substituant,
chaque W représente indépendamment un atome d'oxygène, un atome de soufre, $NR^1$, ou $C(R^2)_2$,
$R^1$ représente un atome d'hydrogène, un groupe alkyle, un groupe alcényle, un groupe alcynyle, un groupe aryle, ou un groupe hétéroaryle, et
chaque $R^2$ représente indépendamment un groupe cyano, un groupe acyle, un groupe (per)fluoroalkyle, ou un groupe (per)fluoroaryle.

**6.** Composé selon la revendication 5,
dans lequel le composé ayant un motif répétitif représenté par la formule (1-2) est un composé ayant une structure partielle représentée par la formule (1-2A) suivante ;

Formule (1-2A)

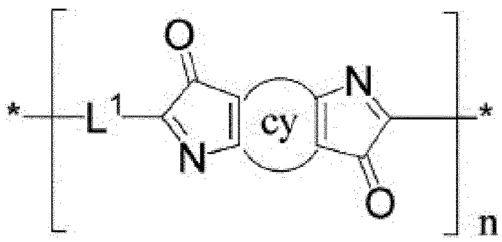

dans la formule (1-2A),

Cy représente un cycle aromatique ou un cycle aromatique hétérocyclique qui peut avoir un substituant,
$L^1$ représente une liaison simple ou un groupe de liaison divalent,
n représente un nombre entier égal ou supérieur à 2, et deux ou plus de deux Cy et $L^1$ peuvent être identiques les uns aux autres ou différents les uns des autres.

**7.** Composé selon la revendication 5,
dans lequel le composé ayant un motif répétitif représenté par la formule (1-2) est un composé ayant une structure partielle représentée par la formule (1-2B) suivante et $V^1$ dans la formule (1-2B) est un groupe de liaison divalent représenté par l'une quelconque des formules (V-1) et (V-17) suivantes ;

Formule (1-2B)

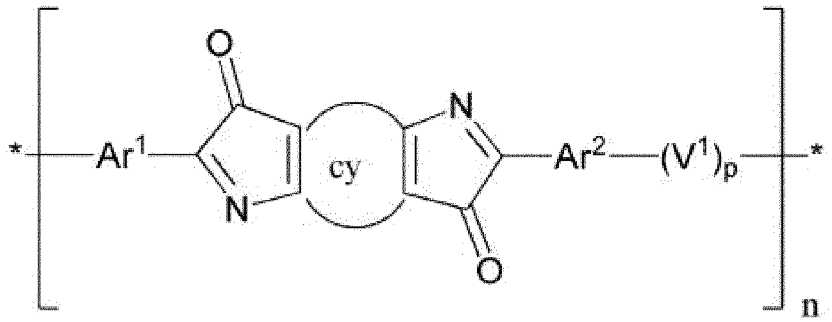

dans la formule (1-2B),

Cy représente un cycle aromatique ou un cycle aromatique hétérocyclique qui peut avoir un substituant,
chacun parmi $Ar^1$ et $Ar^2$ représente indépendamment un groupe hétéroarylène ou un groupe arylène,
$V^1$ représente une liaison simple ou un groupe de liaison divalent,
p représente un nombre entier allant de 1 à 6, quand p est égal ou supérieur à 2, deux ou plus de deux $V^1$ peuvent être identiques les uns aux autres ou différents les uns des autres,
n représente un nombre entier égal ou supérieur à 2, et deux ou plus de deux Cy, $V^1$, $Ar^1$, et $Ar^2$ peuvent être identiques les uns aux autres ou différents les uns des autres ;

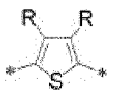
(V-1)

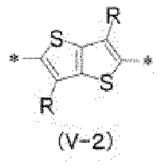
(V-2)

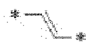
(V-3)

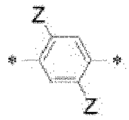
(V-4)

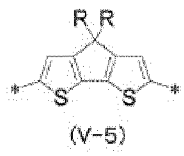
(V-5)

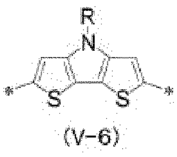
(V-6)

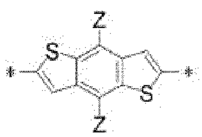
(V-7)

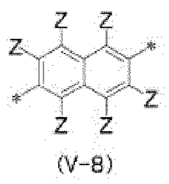
(V-8)

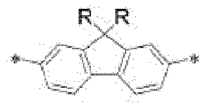
(V-9)

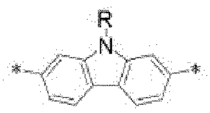
(V-10)

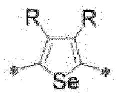
(V-11)

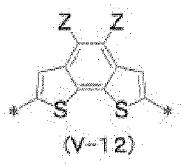
(V-12)

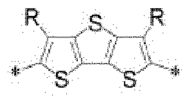
(V-13)

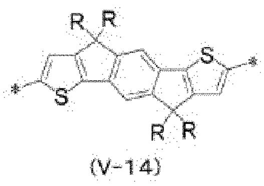
(V-14)

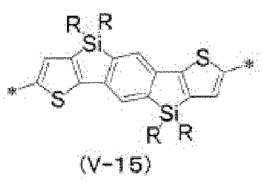
(V-15)

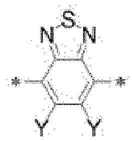
(V-16)

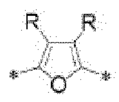
(V-17)

chaque R dans les formules (V-1), (V-2), (V-5), (V-6), (V-9) à (V-11), (V-13) à (V-15), et (V-17) représente indépendamment un atome d'hydrogène ou un groupe alkyle, des R adjacents les uns aux autres peuvent former un cycle en étant liés les uns aux autres,
chaque Z dans les formules (V-4), (V-7), (V-8), et (V-12) représente indépendamment un atome d'hydrogène, un groupe alkyle, ou un groupe alcoxy, des Z adjacents les uns aux autres peuvent former un cycle en étant

liés les uns aux autres,
chaque Y dans la formule (V-16) représente indépendamment un atome d'hydrogène, un groupe alkyle, un groupe alcoxy, un groupe CN, ou un atome F, et des Y adjacents les uns aux autres peuvent former un cycle en étant liés les uns aux autres.

**8.** Composé selon la revendication 7,
dans lequel dans la formule (1-2B), chacun parmi $Ar^1$ et $Ar^2$ est indépendamment un groupe de liaison divalent représenté par la formule (4-1), (4-2), ou (4-3) suivante ;

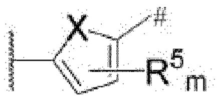

Formule (4-1)

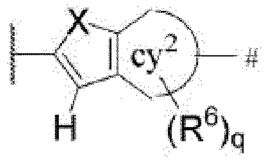

Formule (4-2)

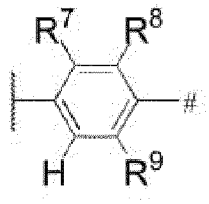

Formule (4-3)

dans les formules (4-1) à (4-3),

X représente un atome de soufre, un atome d'oxygène, ou un atome Se,
$Cy^2$ représente une structure dans laquelle 1 à 4 cycles sont condensés,
chacun parmi $R^5$ à $R^9$ représente indépendamment un atome d'hydrogène ou un substituant,
m est 2,
q représente un nombre entier allant de 0 à 6, quand q est supérieur ou égal à 2, deux ou plus de deux $R^6$ peuvent être identiques les uns aux autres ou différents les uns des autres,
la ligne ondulée représente une position de liaison d'un fragment dans lequel un cycle 3H-pyrrol-3-one est condensé, et
# représente une position de liaison à $V^1$.

**9.** Matériau semi-conducteur organique pour un dispositif semi-conducteur organique non émetteur de lumière, comprenant le composé ayant un motif répétitif représenté par la formule (1-2), ou (1-3) selon l'une quelconque des revendications 1 à 8.

**10.** Matériau pour un transistor organique, comprenant le composé ayant un motif répétitif représenté par la formule (1-2), ou (1-3) selon l'une quelconque des revendications 1 à 8.

**11.** Solution de revêtement pour un dispositif semi-conducteur organique non émetteur de lumière, comprenant le composé ayant un motif répétitif représenté par la formule (1-2), ou (1-3) selon l'une quelconque des revendications 1 à 8.

**12.** Film semi-conducteur organique pour un dispositif semi-conducteur organique non émetteur de lumière, comprenant le composé ayant un motif répétitif représenté par la formule (1-2), ou (1-3) selon l'une quelconque des revendications 1 à 8.

**13.** Composé représenté par la formule (6) suivante ;

Formule (6)

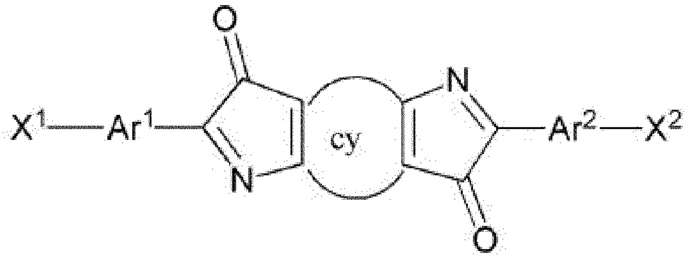

dans la formule (6),

Cy représente un cycle aromatique ou un cycle aromatique hétérocyclique qui peut avoir un substituant,
chacun parmi $Ar^1$ et $Ar^2$ représente indépendamment un cycle aromatique hétérocyclique ou un cycle aromatique, et
chacun parmi $X^1$ et $X^2$ représente indépendamment un atome d'hydrogène, un atome d'halogène, un groupe trifluorométhylsulfonyle, un groupe trialkylstannyle, un groupe ester d'acide borique, ou $-B(OH)_2$.

**14.** Composé représenté par la formule (7) suivante ;

Formule (7)

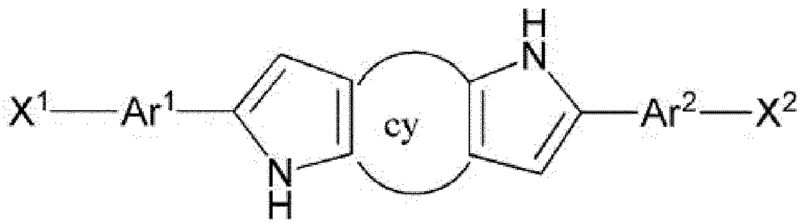

dans la formule (7),

Cy représente un cycle aromatique ou un cycle aromatique hétérocyclique qui peut avoir un groupe alkyle ayant 1 à 50 atomes de carbone en tant que substituant,
chacun parmi $Ar^1$ et $Ar^2$ représente indépendamment un cycle aromatique hétérocyclique ou un cycle aromatique, et
chacun parmi $X^1$ et $X^2$ représente indépendamment un atome d'halogène, un groupe trifluorométhylsulfonyle, un groupe trialkylstannyle, un groupe ester d'acide borique, ou $-B(OH)_2$.

FIG. 1

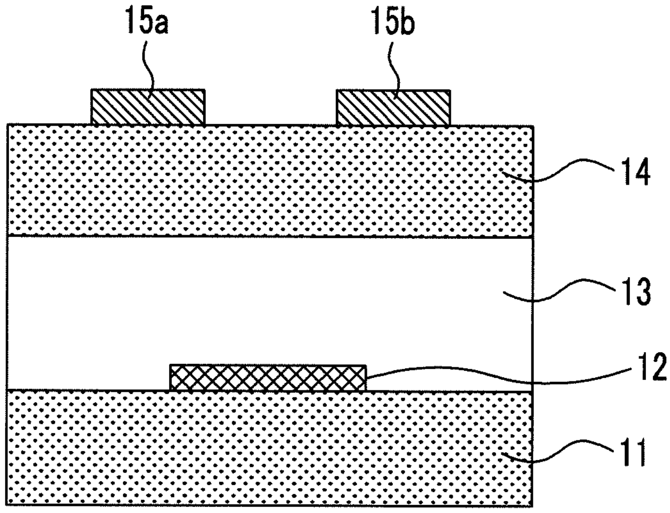


FIG. 2

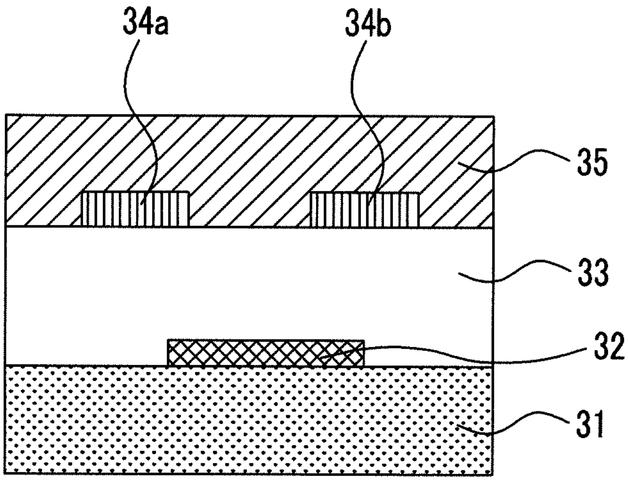

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010535270 A
- JP 2008056814 A
- WO 2013066973 A
- US 7928249 B
- WO 2013065836 A
- JP 2012177104 A